(19) Europäisches Patentamt
European Patent Office
Office européen des brevets

(11) EP 1 396 938 A1

(12) EUROPEAN PATENT APPLICATION
published in accordance with Art. 158(3) EPC

(43) Date of publication:
**10.03.2004 Bulletin 2004/11**

(21) Application number: **02724674.3**

(22) Date of filing: **02.05.2002**

(51) Int Cl.[7]: **H03M 7/38**

(86) International application number:
**PCT/JP2002/004384**

(87) International publication number:
**WO 2002/091588 (14.11.2002 Gazette 2002/46)**

(84) Designated Contracting States:
**AT BE CH CY DE DK ES FI FR GB GR IE IT LI LU MC NL PT SE TR**

(30) Priority: **07.05.2001 JP 2001136265**

(71) Applicant: **MATSUSHITA ELECTRIC INDUSTRIAL CO., LTD.**
**Kadoma-shi, Osaka 571-8501 (JP)**

(72) Inventors:
- **BANBA, Yutaka**
  **Yamato-shi, Kanagawa 242-0012 (JP)**
- **TAKAGI, Yoshiaki**
  **Yokohama-shi, Kanagawa 225-0014 (JP)**

(74) Representative: **Holmes, Miles et al**
**Novagraaf International S.A.**
**25, avenue du Pailly**
**1220 Les Avanchets, Geneva (CH)**

(54) **SUB-BAND ADAPTIVE DIFFERENTIAL PULSE CODE MODULATION/ENCODING APPARATUS, SUB-BAND ADAPTIVE DIFFERENTIAL PULSE CODE MODULATION/ENCODING METHOD, WIRELESS TRANSMISSION SYSTEM, SUB-BAND ADAPTIVE DIFFERENTIAL PULSE CODE MODULATION/DECODING APPARATUS, SUB-BAND ADAPTIVE DIFFERENTIAL PULSE CODE MODULATION/D**

(57) A sub-band adaptive differential pulse code modulation/encoding apparatus includes means (102, 103, 104, 105) having a predetermined asymmetric impulse response for receiving an audio signal and band-dividing the received audio signal into a predetermined number of sub-bands, so as to obtain a plurality of band-divided sub-band audio signals, a plurality of quantization means (110, 111, 112, 113) for quantizing the band-divided sub-band audio signals with the predetermined number of sub-bands, and encoding means (115) for performing adaptive differential pulse code modulation/encoding of the quantized sub-band audio signals.

FIG. 1

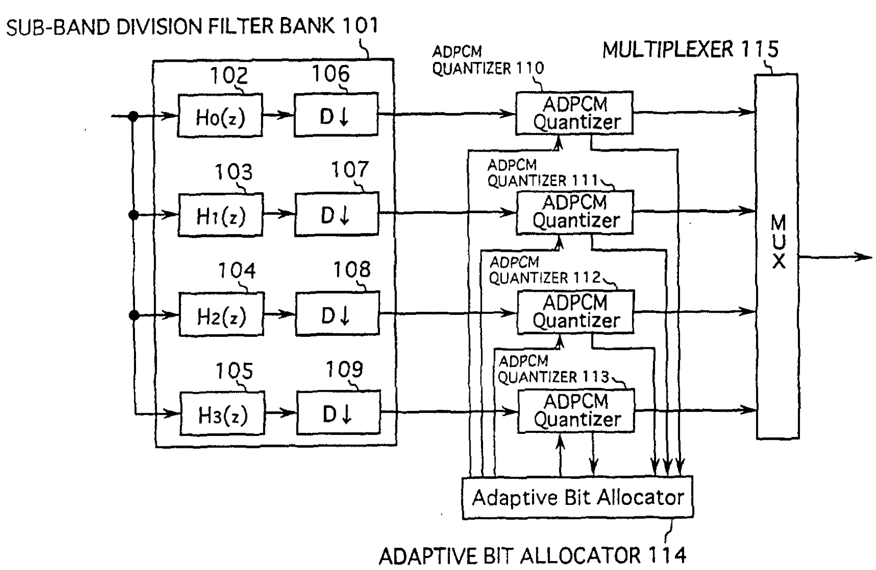


EP 1 396 938 A1

## Description

Technical Field of Invention

This invention is related to a sub-band adaptive differential pulse code modulation/encoding apparatus, hereinafter as simply referred to as "a sub-band ADPCM encoding apparatus", a sub-band adaptive differential pulse code modulation/encoding method, hereinafter as simply referred to as "a sub-band ADPCM encoding method", a wireless transmission system, a sub-band adaptive differential pulse code modulation/decoding apparatus, hereinafter as simply referred to as "a sub-band ADPCM decoding apparatus", a sub-band adaptive differential pulse code modulation/decoding method, hereinafter as simply referred to as "a sub-band ADPCM decoding method", and a wireless receiving system.

Background Art

In conventional, this kind of methods of sub-band ADPCM encoding and sub-band ADPCM decoding is well known as disclosed in Kohyo (Japan Unexamined Patent Publication) No. H03-504787.

As shown in Figure 16, the conventional sub-band ADPCM encoding apparatus 600 comprises: a division filter bank 602 having a tree structure of 64 taps; an ADPCM quantizer 603; an ADPCM quantizer 604; an ADPCM quantizer 605; an ADPCM quantizer 606; a multiplexer 607; a de-multiplexer 608; an ADPCM de-quantizer 609; an ADPCM de-quantizer 610; an ADPCM de-quantizer 611; an ADPCM de-quantizer 612; and a synthesis filter bank 613 having a tree structure of 64 taps. The conventional sub-band ADPCM encoding apparatus further comprises an adaptive bit allocator 614 and an adaptive bit allocator 615, both of which are designed to operate the adaptive bit allocation in case of necessity.

The above described conventional sub-band ADPCM encoding method and sub-band ADPCM encoding method, however, has a problem in that its structure becomes complex, due to the use of the sub-band filter band having a tree structure, as the number of divided sub-bands increases, thereby increasing the band division calculations, and delay.

In order to solve the foregoing conventional problem, it is therefore an object of the present invention to provide a sub-band ADPCM encoding method, a sub-band ADPCM decoding method, a sub-band ADPCM encoding apparatus, a sub-band ADPCM decoding apparatus, a wireless transmission system, and a wireless receiving system, that can reduce delay and have little calculation.

Disclosure of the invention

It is a first object of the present invention to provide a sub-band adaptive differential pulse code modulation/encoding apparatus comprising: sub-band audio signal obtaining means having a predetermined asymmetric impulse response for receiving an audio signal and band-dividing the received audio signal into a predetermined number of sub-bands, so as to obtain a plurality of band-divided sub-band audio signals; a plurality of quantization means for quantizing said band-divided sub-band audio signals with the predetermined number of sub-bands; and encoding means for performing adaptive differential pulse code modulation/encoding the quantized sub-band audio signals. According to the present invention, the sub-band adaptive differential pulse code modulation/encoding apparatus comprises a band division filter having a predetermined asymmetric impulse response, thereby making it possible to reduce a group delay due to the band filtering in comparison with that of the conventional band division filter having a symmetric impulse response. Even when the number of divided sub-bands increases, the sub-band adaptive differential pulse code modulation/encoding apparatus can further reduce the scale of its hardware and a group delay due to the band filtering in comparison with those of the conventional band division filter having a tree structure.

It is a second object of the present invention to provide the sub-band adaptive differential pulse code modulation/encoding apparatus, wherein said plural quantization means are operated to vector-quantize said plural sub-band audio signals, respectively. According to the present invention, the sub-band adaptive differential pulse code modulation/encoding apparatus comprises a band division filter having a predetermined asymmetric impulse response, thereby making it possible to reduce a group delay due to the band filtering in comparison with that of the conventional band division filter having a symmetric impulse response, and prevent a quality degradation of the audio signal decoded from the coded audio signal at a low bit rate.

It is a third object of the present invention to provide the sub-band adaptive differential pulse code modulation/encoding apparatus, wherein said plural quantization means are selectively operated to: vector-quantize the sub-band audio signals in the sub-bands in which the sub-band audio signals are previously designated to be vector-quantized; and scalar-quantize the sub-band audio signals in the sub-bands in which the sub-band audio signals are previously designated to be scalar-quantized. According to the present invention, the sub-band adaptive differential pulse code modulation/encoding apparatus comprises a band division filter having a predetermined asymmetric impulse response, thereby making it possible to reduce a group delay due to the band filtering in comparison with that of the conventional band division filter having a symmetric impulse response. The sub-band adaptive differential pulse code modulation/encoding apparatus is further operated to judge which should be performed the scalar quantization or the vector quantization for the sub-bands, to then perform the selected quantization, thereby making it possible to process real timely even when the apparatus is insufficient in the throughput capacity for the vector quantization.

It is a fourth object of the present invention to provide the sub-band adaptive differential pulse code modulation/encoding apparatus, wherein said plural quantization means have: a quantization table storing unit for previously storing, into a quantization table, a plurality of code vectors used to vector-quantize said plural sub-band audio signals; a quantization table updation unit for updating said previously stored plural code vectors on the basis of a signal pattern of said plural sub-band audio signals; and a quantization table transmitting unit for judging whether a silent state, in which the level of said received audio signal is less than a predetermined minimum signal level, is kept over a predetermine duration or not, and transmitting said updated quantization table on the basis of the judgment result, said plural quantization means being operated to vector-quantize said plural sub-band audio signals, respectively, on the basis of said updated quantization table when the transmission of said updated quantization table is completed. According to the present invention, the sub-band adaptive differential pulse code modulation/encoding apparatus comprises a band division filter having a predetermined asymmetric impulse response, thereby making it possible to reduce a group delay due to the band filtering in comparison with that of the conventional band division filter having a symmetric impulse response. The sub-band adaptive differential pulse code modulation/encoding apparatus is further operated: to learn a vector pattern adaptable to the vector pattern of the audio signal when the vector quantization is performed; to update the vector pattern stored in the vector quantization table; and to then transmit, to the destination, the vector quantization table in which the updated vector pattern is stored, thereby rising a ratio of signal to noise.

It is a fifth object of the present invention to provide the sub-band adaptive differential pulse code modulation/encoding apparatus, wherein said sub-band audio signal obtaining means includes a plurality of band division filters each having an asymmetric finite impulse response, and said plural band division filters being operated to band-divide said audio signal into said plural predetermined sub-bands. According to the present invention, the sub-band adaptive differential pulse code modulation/encoding apparatus comprises a band division filter having a predetermined asymmetric impulse response, thereby making it possible to reduce a group delay due to the band filtering in comparison with that of the conventional band division filter having a symmetric impulse response. Even when the number of divided sub-bands increases, the sub-band adaptive differential pulse code modulation/encoding apparatus can further reduce the scale of its hardware and a group delay due to the band filtering in comparison with those of the conventional band division filter having a tree structure.

It is a sixth object of the present invention to provide the sub-band adaptive differential pulse code modulation/encoding apparatus, said band division filters respectively include: a filter coefficient determining unit for determining a plurality of filter coefficients; and a filtering unit for filtering a predetermined sub-band audio signal from said audio signal on the basis of said determined filter coefficients, and said filter coefficient determining unit being operated to perform a cosine-modulation with a predetermined phase difference with respect to an axis of symmetry of the symmetric finite impulse response, and to determine said plural filter coefficients, so that each of the band division filters has a predetermined asymmetric impulse response. According to the present invention, the sub-band adaptive differential pulse code modulation/encoding apparatus comprises a band division filter having a predetermined asymmetric impulse response, thereby making it possible to reduce a group delay due to the band filtering in comparison with that of the conventional band division filter having a symmetric impulse response. Even when the number of divided sub-bands increases, the sub-band adaptive differential pulse code modulation/encoding apparatus can further reduce the scale of its hardware and a group delay due to the band filtering in comparison with those of the conventional band division filter having a tree structure.

It is a seventh object of the present invention to provide a sub-band adaptive differential pulse code modulation/encoding apparatus comprising: a microphone for inputting an audio and converting the inputted audio into an audio signal; discrete audio signal obtaining means for sampling said converted audio signal at predetermined intervals, so as to obtain a discrete audio signal; sub-band audio signal obtaining means having a predetermined asymmetric impulse response for receiving an audio signal and band division the received audio signal into a predetermined number of sub-bands, so as to obtain a plurality of band-divided sub-band discrete audio signals; a plurality of down-samplers for down-sampling said band-divided sub-band discrete audio signals for a predetermined sampling frequencies of said plural sub-bands to thin down said divided sub-band discrete audio signals a plurality of quantization means for vector-quantizing said down-sampled sub-band discrete audio signals with the predetermined number of sub-bands; and encoding means for performing adaptive differential pulse code modulation/encoding the quantized sub-band audio signals. According to the present invention, the sub-band adaptive differential pulse code modulation/encoding apparatus comprises a band division filter having a predetermined asymmetric impulse response, thereby making it possible to reduce a group delay due to the band filtering in comparison with that of the conventional band division filter having a symmetric impulse response. Even when the number of divided sub-bands increases, the sub-band adaptive differential pulse code modulation/encoding apparatus can further reduce the scale of its hardware and a group delay due to the band filtering in comparison with those of the conventional band division filter having a tree structure.

It is an eighth object of the present invention to provide the sub-band adaptive differential pulse code modulation/encoding apparatus, wherein said plural quantization means include: a quantization table storing unit for previously storing, into a quantization table, a plurality of code vectors used to vector-quantize said respective plural sub-band audio signals, and a plurality of index numbers corresponding to said respective code vectors; a de-quantizer for de-quantizing the code vectors stored in said quantization table storing unit; a scale factor adaptor for adapting a scale factor to the de-quantized code vector in accordance with the tendency of the variation of a plurality of previous code vectors, said scale factor adaptor being operated to increase the scale factor when the variation of the previous code vectors shows a strong tendency, said scale factor adaptor being operated to decrease the scale factor when the variation of the previous code vectors shows a weak tendency; a predictor for calculating a predictive value on the basis of a plurality of previous de-quantized values; an input buffer for storing therein a plurality of sampled data on the sub-band audio signals for the next calculation; and a least mean square error calculator for adding the de-quantized value de-quantized by said de-quantizer and the predictive value calculated by said predictor to obtain a predictive value of a plurality of sampled data on the next obtained sub-band audio signals, subtracting said predictive value of a plurality of sampled data on the next obtained sub-band audio signals from said sub-band audio signals stored in said input buffer, and calculating a least mean square error, so as to select one having the least error from the code vectors on the basis of the subtracted result, said least mean square error calculator being operated to select one code vector from among said plural code vectors stored in said quantization table storing unit, so as to have the calculated least mean square error, and said plural quantization means performing a vector-quantize on the basis of said selected one code vector. According to the present invention, the sub-band adaptive differential pulse code modulation/encoding apparatus comprises a band division filter having a predetermined asymmetric impulse response, thereby making it possible to reduce a group delay due to the band filtering in comparison with that of the conventional band division filter having a symmetric impulse response. Even when the number of divided sub-bands increases, the sub-band adaptive differential pulse code modulation/encoding apparatus can further reduce the scale of its hardware and a group delay due to the band filtering in comparison with those of the conventional band division filter having a tree structure.

It is a ninth object of the present invention to provide the sub-band adaptive differential pulse code modulation/encoding apparatus, wherein said plural quantization means include: a quantization table updating unit for updating a vector quantization table by learning, by a predetermined learning method, the code vector capable of further reducing the error on the basis of the subtracted result obtained by subtracting the predictive value of the plural sampled data on the next obtained sub-band audio signal from said sub-band audio signals stored in said input buffer; a state judging unit for judging whether the level of said received audio signal is no more than a predetermined minimum signal level or not, and further judging whether the received audio signal is kept said predetermined minimum signal level or below over a predetermined duration or not; and a quantization table transmitting unit for transmitting said updated quantization table to a predetermined destination, said quantization table transmitting unit being operated to transmit said updated quantization table to the predetermined destination when said state judging unit is operated to judge that the level of said received audio signal is no more than the predetermined minimum signal level, and judge that said received audio signal is kept said predetermined minimum signal level or below over the predetermined duration, said quantization table transmitting unit being operated to interrupt the transmission of said updated quantization table when said state judging unit is operated to judge that the level of said received audio signals exceeds the predetermined minimum signal level during the transmission of said updated quantization table for the destination, said quantization table transmitting unit being further operated to resume transmitting said updated quantization table when said state judging unit is operated to judge that the level of said received audio signal is no more than the predetermined minimum signal level, and judge that the inputted audio signal is kept said predetermined minimum signal level or below over the predetermined duration during the transmission of the updated quantization table for the destination, said plural quantizers being operated to perform the vector quantization on the basis of said updated quantization table when the transmission of said updated quantization table is completed. According to the present invention, the sub-band adaptive differential pulse code modulation/encoding apparatus comprises a band division filter having a predetermined asymmetric impulse response, thereby making it possible to reduce a group delay due to the band filtering in comparison with that of the conventional band division filter having a symmetric impulse response, and prevent a quality degradation of the audio signal decoded from the coded audio signal at a low bit rate.

It is a 10th object of the present invention to provide the sub-band adaptive differential pulse code modulation/encoding apparatus, wherein said vector quantization means is operated to calculate an energy of said plural sub-band audio signals de-quantized by said de-quantizer, and to adaptively allocate the number of bits on the basis of the ratio of the energy of said calculated plural sub-band audio signals. According to the present invention, the sub-band adaptive differential pulse code modulation/encoding apparatus comprises a band division filter having a predetermined asymmetric impulse response, thereby making it possible to reduce a group delay due to the band filtering in comparison with that of the conventional band division filter having a symmetric impulse response, and prevent a quality degradation of the audio signal decoded from the coded audio signal at a low bit rate.

It is an 11th object of the present invention to provide a sub-band adaptive differential pulse code modulation/encoding method comprising: a preparing process of preparing a plurality of sub-band audio signal obtaining means having a predetermined asymmetric impulse response for receiving an audio signal and band-dividing the received audio signal into a predetermined number of sub-bands, so as to obtain a plurality of band-divided sub-band audio signals, a plurality of quantization means for quantizing said band-divided sub-band audio signals with the predetermined number of sub-bands, and encoding means for performing adaptive differential pulse code modulation/encoding said quantized sub-band audio signals; a plurality of sub-bands audio signal obtaining processes of making said band division filter band-divide said received audio signal into said predetermined number of sub-bands, so as to obtain said plural band-divided sub-band audio signals, respectively; a plurality of quantizing processes of making said plural quantization means respectively quantize said band-divided sub-band audio signals with the predetermined number of sub-bands; and an encoding process of performing adaptive differential pulse code modulation/encoding said quantized plural sub-band audio signals by said plurality of quantization means. According to the present invention, the sub-band adaptive differential pulse code modulation/encoding method comprises the preparing process of preparing a band division filter having a predetermined asymmetric impulse response, thereby making it possible to reduce a group delay due to the band filtering in comparison with that of the conventional band division filter having a symmetric impulse response. Even when the number of divided sub-bands increases, the sub-band adaptive differential pulse code modulation/encoding method can further reduce the scale of its hardware and a group delay due to the band filtering in comparison with those of the conventional band division filter having a tree structure.

It is a 12th object of the present invention to provide the sub-band adaptive differential pulse code modulation/encoding method, wherein said plurality of quantization processes of respectively making said plural quantization means vector-quantize said plural sub-band audio signals. According to the present invention, the sub-band adaptive differential pulse code modulation/encoding method comprises the preparing process of preparing a band division filter having a predetermined asymmetric impulse response, thereby making it possible to reduce a group delay due to the band filtering in comparison with that of the conventional band division filter having a symmetric impulse response, and prevent a quality degradation of the audio signal decoded from the coded audio signal at a low bit rate.

It is a 13th object of the present invention to provide the sub-band adaptive differential pulse code modulation/encoding method, wherein said plurality of quantization processes of: selectively performing the vector-quantization of the sub-band audio signals in the sub-bands in which the sub-band audio signals are previously designated to be vector-quantized; and performing scalar-quantization of the sub-band audio signals in the sub-bands in which the sub-band audio signals are previously designated to be scalar-quantized. According to the present invention, the sub-band adaptive differential pulse code modulation/encoding method comprises the preparing process of preparing a band division filter having a predetermined asymmetric impulse response, thereby making it possible to reduce a group delay due to the band filtering in comparison with that of the conventional band division filter having a symmetric impulse response. In the sub-band adaptive differential pulse code modulation/encoding method, each of the quantization processes includes the steps of: judging which should be performed the scalar quantization or the vector quantization for the sub-bands; and performing the selected quantization, thereby making it possible to process real timely even when the throughput capacity for the vector quantization is insufficient.

It is a 14th object of the present invention to provide the sub-band adaptive differential pulse code modulation/encoding method, wherein said preparing process of preparing said plural quantization means having: a quantization table storing unit for previously storing, into a quantization table, a plurality of code vectors used to vector-quantize said plural sub-band audio signals; a quantization table updation unit for updating said previously stored plural code vectors on the basis of a signal pattern of said plural sub-band audio signals; and a quantization table transmitting unit for judging whether a silent state, in which the level of said received audio signal is less than a predetermined minimum signal level, is kept over a predetermine duration or not, and transmitting said updated quantization table on the basis of the judgment result, said plural quantizing processes further including: a quantization table storing process of previously storing, into a quantization table, a plurality of code vectors used to vector-quantize said plural sub-band audio signals; a quantization table updation process of updating said previously stored plural code vectors on the basis of a signal pattern of said plural sub-band audio signals; and a quantization table transmitting process of judging whether a silent state, in which the level of said received audio signal is less than a predetermined minimum signal level, is kept over a predetermine duration or not, and transmitting said updated quantization table on the basis of the judgment result, in said plural quantizing processes, said plural sub-band audio signals, respectively, are vector-quantized on the basis of said updated quantization table when the transmission of said updated quantization table is completed. According to the present invention, the sub-band adaptive differential pulse code modulation/encoding method comprises the preparing process of preparing a band division filter having a predetermined asymmetric impulse response, thereby making it possible to reduce a group delay due to the band filtering in comparison with that of the conventional band division filter having a symmetric impulse response. In the sub-band adaptive differential pulse code modulation/encoding method, each of the plural quantizing processes includes the steps of: learning a vector pattern adaptable to the vector pattern of the audio signal when the vector quantization is performed; updating the vector pattern stored in the vector quantization table; and transmitting, to the destination, the vector quantization table in which the updated vector pattern is stored, thereby rising a ratio of signal to noise.

It is a 15th object of the present invention to provide a wireless transmission system comprising: sub-band audio signal obtaining means having a predetermined asymmetric impulse response for receiving an audio signal and band-dividing the received audio signal into a predetermined number of sub-bands, so as to obtain a plurality of band-divided sub-band audio signals; a plurality of quantization means for quantizing said band-divided sub-band audio signals with the predetermined number of sub-bands; and encoding means for performing adaptive differential pulse code modulation/encoding the quantized sub-band audio signals. According to the present invention, the wireless transmission system comprises a band division filter having a predetermined asymmetric impulse response, thereby making it possible to reduce a group delay due to the band filtering in comparison with that of the conventional band division filter having a symmetric impulse response. Even when the number of divided sub-bands increases, the wireless transmission system can further reduce the scale of its hardware and a group delay due to the band filtering in comparison with those of the conventional band division filter having a tree structure.

It is a 16th object of the present invention to provide the wireless transmission system, wherein said plural quantization means are operated to vector-quantize said plural sub-band audio signals, respectively. According to the present invention, the wireless transmission system comprises a band division filter having a predetermined asymmetric impulse response, thereby making it possible to reduce a group delay due to the band filtering in comparison with that of the conventional band division filter having a symmetric impulse response, and prevent a quality degradation of the audio signal decoded from the coded audio signal at a low bit rate.

It is a 17th object of the present invention to provide the wireless transmission system, wherein said plural quantization means are selectively operated to: vector-quantize the sub-band audio signals in the sub-bands in which the sub-band audio signals are previously designated to be vector-quantized; and scalar-quantize the sub-band audio signals in the sub-bands in which the sub-band audio signals are previously designated to be scalar-quantized. According to the present invention, the wireless transmission system comprises a band division filter having a predetermined asymmetric impulse response, thereby making it possible to reduce a group delay due to the band filtering in comparison with that of the conventional band division filter having a symmetric impulse response. The wireless transmission system is further operated to judge which should be performed the scalar quantization or the vector quantization for the sub-bands, to then perform the selected quantization, thereby making it possible to process real timely even when the wireless transmission system is insufficient in the throughput capacity for the vector quantization.

It is an 18th object of the present invention to provide the wireless transmission system, wherein said plural quantization means have: a quantization table storing unit for previously storing, into a quantization table, a plurality of code vectors used to vector-quantize said plural sub-band audio signals; a quantization table updation unit for updating said previously stored plural code vectors on the basis of a signal pattern of said plural sub-band audio signals; and a quantization table transmitting unit for judging whether a silent state, in which the level of said received audio signal is less than a predetermined minimum signal level, is kept over a predetermine duration or not, and transmitting said updated quantization table on the basis of the judgment result, said plural quantization means being operated to vector-quantize said plural sub-band audio signals, respectively, on the basis of said updated quantization table when the transmission of said updated quantization table is completed. According to the present invention, wireless transmission system comprises a band division filter having a predetermined asymmetric impulse response, thereby making it possible to reduce a group delay due to the band filtering in comparison with that of the conventional band division filter having a symmetric impulse response. The wireless transmission system is further operated: to learn a vector pattern adaptable to the vector pattern of the audio signal when the vector quantization is performed; to update the vector pattern stored in the vector quantization table; and to then transmit, to the destination, the vector quantization table in which the updated vector pattern is stored, thereby rising a ratio of signal to noise.

It is a 19th object of the present invention to provide a sub-band adaptive differential pulse code modulation/decoding apparatus comprising: sub-band separating means for receiving a coded audio signal encoded from a plurality of sub-band audio signals including a plurality of sub-bands, and separating said plural sub-band coded audio signals from said coded audio signal; a plurality of de-quantization means for de-quantizing said plural sub-band coded audio signals with a predetermined number of sub-bands; and a plurality of band synthesizing means for band-synthesizing an audio signal from said de-quantized plural sub-band audio signals. According to the present invention, the sub-band adaptive differential pulse code modulation/decoding apparatus comprises a band division filter having a predetermined asymmetric impulse response, thereby making it possible to reduce a group delay due to the band filtering in comparison with that of the conventional band division filter having a symmetric impulse response. Even when the number of divided sub-bands increases, the sub-band adaptive differential pulse code modulation/decoding apparatus can further reduce the scale of its hardware and a group delay due to the band filtering in comparison with those of the conventional band division filter having a tree structure.

It is a 20th object of the present invention to provide the sub-band adaptive differential pulse code modulation/decoding apparatus, wherein said plural de-quantization means are operated to vector-quantize said plural sub-band audio signals, respectively. According to the present invention, the sub-band adaptive differential pulse code modulation/decoding apparatus comprises a band division filter having a predetermined asymmetric impulse response, thereby making it possible to reduce a group delay due to the band filtering in comparison with that of the conventional band division filter having a symmetric impulse response, and prevent a quality degradation of the audio signal decoded from the coded audio signal at a low bit rate.

It is a 21st object of the present invention to provide the sub-band adaptive differential pulse code modulation/decoding apparatus, wherein said plural de-quantization means selectively operated to: vector-de-quantize the sub-band audio signals in the sub-bands in which the sub-band audio signals are previously designated to be vector-de-quantized; and scalar-de-quantize the sub-band audio signals in the sub-bands in which the sub-band audio signals are previously designated to be scalar-de-quantized. According to the present invention, the sub-band adaptive differential pulse code modulation/decoding apparatus comprises a band division filter having a predetermined asymmetric impulse response, thereby making it possible to reduce a group delay due to the band filtering in comparison with that of the conventional band division filter having a symmetric impulse response. The sub-band adaptive differential pulse code modulation/decoding apparatus is further operated to judge which should be performed the scalar quantization or the vector quantization for the sub-bands, to then perform the selected quantization, thereby making it possible, to process real timely even when the apparatus is insufficient in the throughput capacity for the vector quantization.

It is a 22nd object of the present invention to provide the sub-band adaptive differential pulse code modulation/decoding apparatus, wherein said plural de-quantization means have: a quantization table storing unit for previously storing therein a vector quantization table that is used to vector-quantize said plural sub-band audio signals; a quantization table receiving unit for receiving the updated vector quantization table in response to the reception of a predetermined recognition signal which is indicative of the transmission of said vector quantization table; and decoding process return means for immediately returning to a decoding process of decoding said coded audio signal in response to the reception of a predetermined recognition signal which is indicative of the transmission of said coded audio signal when the transmission of said updated vector quantization table is interrupted, said plural de-quantization means being operated to vector-de-quantize said plural sub-band audio signals, respectively, on the basis of said updated quantization table when the transmission of said quantization table is completed. According to the present invention, the sub-band adaptive differential pulse code modulation/decoding apparatus comprises a band division filter having a predetermined asymmetric impulse response, thereby making it possible to reduce a group delay due to the band filtering in comparison with that of the conventional band division filter having a symmetric impulse response. The sub-band adaptive differential pulse code modulation/decoding apparatus is further operated: to learn a vector pattern adaptable to the vector pattern of the audio signal when the vector quantization is performed; to update the vector pattern stored in the vector quantization table; and to then transmit, to the destination, the vector quantization table in which the updated vector pattern is stored, thereby rising a ratio of signal to noise.

It is a 23rd object of the present invention to provide the sub-band adaptive differential pulse code modulation/decoding apparatus, wherein said band synthesizing means includes: a band synthesis unit having a predetermined asymmetric finite impulse response; and a filter coefficient determining unit for determining a plurality of filter coefficients, said filter coefficient determining unit being operated to perform a cosine-modulation with a predetermined phase difference with respect to an axis of symmetry of the symmetric finite impulse response, and to determine said plural filter coefficients, so that each of the band synthesis means has a predetermined asymmetric impulse response. According to the present invention, the sub-band adaptive differential pulse code modulation/decoding apparatus comprises a band division filter having a predetermined asymmetric impulse response, thereby making it possible to reduce a group delay due to the band filtering in comparison with that of the conventional band division filter having a symmetric impulse response. Even when the number of divided sub-bands increases, the sub-band adaptive differential pulse code modulation/decoding apparatus can further reduce the scale of its hardware and a group delay due to the band filtering in comparison with those of the conventional band division filter having a tree structure.

It is a 24th object of the present invention to provide a sub-band adaptive differential pulse code modulation/decoding apparatus comprising: a sub-band separating means for receiving a plurality of sub-band audio signals, for a plurality of sub-bands, encoded from a plurality of audio signals of said plural sub-bands, and separating a plurality of index numbers respectively corresponding to a plurality of code vectors which is used to vector-quantize said plural sub-band coded audio signals to obtain said plural sub-band audio signals; a plurality of de-quantization means for vector-de-quantizing to obtain said plural sub-band audio signals on the basis of the separated index numbers; an up-sampler for up-sampling for up-sampling said predetermined plural sub-band audio signals so as to interpolate the thinned down sampled values into the plural sub-band audio signals down-sampled for thinning down; and a band synthesizing means for band-synthesizing said audio signal from said sub-band audio components having said plural sub-band audio signals. According to the present invention, the sub-band adaptive differential pulse code modulation/decoding apparatus comprises a band division filter having a predetermined asymmetric impulse response, thereby making it possible to reduce a group delay due to the band filtering in comparison with that of the conventional band division filter having a symmetric impulse response. Even when the number of divided sub-bands increases, the sub-band adaptive differential pulse code modulation/decoding apparatus can further reduce the scale of its hardware and a group delay due to the band filtering in comparison with those of the conventional band division filter having a tree structure.

It is a 25th object of the present invention to provide the sub-band adaptive differential pulse code modulation/decoding apparatus, wherein said plural de-quantization means have: a quantization table storing unit for previously storing therein a vector quantization table that is the same vector quantization table that is obtained by vector-quantizing said plural sub-band audio signals; a plurality of de-quantization means for retrieving a plurality of code vectors from said quantization table storing unit on the basis of said separated index numbers and de-quantizing said retrieved plural code vector, respectively; a scale factor adaptor for adapting a scale factor to the de-quantized code vector in accordance with the tendency of the variation of a plurality of previous code vectors, said scale factor adaptor being operated to increase the scale factor when the variation of the previous code vectors shows a strong tendency, said scale factor adaptor being operated to decrease the scale factor when the variation of the previous code vectors shows a weak tendency; a predictor for calculating a predictive value on the basis of a plurality of previous de-quantized values; and said plural de-quantization means being operated to retrieve said stored plural code vectors from said quantization table on the basis of said plural index numbers, and to de-quantize on the basis of said plural code vectors, respectively. According to the present invention, the sub-band adaptive differential pulse code modulation/decoding apparatus comprises a band division filter having a predetermined asymmetric impulse response, thereby making it possible to reduce a group delay due to the band filtering in comparison with that of the conventional band division filter having a symmetric impulse response. Even when the number of divided sub-bands increases, the sub-band adaptive differential pulse code modulation/decoding apparatus can further reduce the scale of its hardware and a group delay due to the band filtering in comparison with those of the conventional band division filter having a tree structure.

It is a 26th object of the present invention to provide a sub-band adaptive differential pulse code modulation/decoding method comprising: a preparing process of preparing sub-band separating means for receiving a coded audio signal encoded from a plurality of sub-band audio signals including a plurality of sub-bands, and separating said plural sub-band coded audio signals from said coded audio signal, a plurality of de-quantization means for de-quantizing said plural sub-band coded audio signals with a predetermined number of sub-bands, and band synthesizing means for band-synthesizing an audio signal from said de-quantized plural sub-band audio signals; a sub-band separating process of receiving a coded audio signal encoded from a plurality of sub-band audio signals including a plurality of sub-bands, and making said sub-band separating means separate said plural sub-band coded audio signals from said coded audio signal, a plurality of de-quantizing processes of making said plural de-quantization means respectively de-quantize said plural sub-band coded audio signals with the predetermined number of sub-bands; and band synthesizing process of making said synthesizing means band-synthesize said audio signals from said de-quantized plural sub-band audio signals. According to the present invention, the sub-band adaptive differential pulse code modulation/decoding method comprises the preparing process of preparing a band division filter having a predetermined asymmetric impulse response, thereby making it possible to reduce a group delay due to the band filtering in comparison with that of the conventional band division filter having a symmetric impulse response. Even when the number of divided sub-bands increases, the sub-band adaptive differential pulse code modulation/decoding method can further reduce the scale of its hardware and a group delay due to the band filtering in comparison with those of the conventional band division filter having a tree structure.

It is a 27th object of the present invention to provide the sub-band adaptive differential pulse code modulation/decoding method, wherein said plural de-quantizing processes of respectively making said plural de-quantization means vector-quantize said separated plural sub-band audio signals. According to the present invention, the sub-band adaptive differential pulse code modulation/decoding method comprises the preparing process of preparing a band division filter having a predetermined asymmetric impulse response, thereby making it possible to reduce a group delay due to the band filtering in comparison with that of the conventional band division filter having a symmetric impulse response, and prevent a quality degradation of the audio signal decoded from the coded audio signal at a low bit rate.

It is a 28th object of the present invention to provide the sub-band adaptive differential pulse code modulation/decoding method, wherein said plural de-quantizing processes of: selectively making said de-quantization means vector-quantize the sub-band audio signals in the sub-bands in which the sub-band audio signals are previously designated to be vector-de-quantized; and making said de-quantization means scalar-quantize the sub-band audio signals in the sub-bands in which the sub-band audio signals are previously designated to be scalar-de-quantized. According to the present invention, the sub-band adaptive differential pulse code modulation/decoding method comprises the preparing process of preparing a band division filter having a predetermined asymmetric impulse response, thereby making it possible to reduce a group delay due to the band filtering in comparison with that of the conventional band division filter having a symmetric impulse response. In the sub-band adaptive differential pulse code modulation/decoding method, each of the quantization processes includes the steps of: judging which should be performed the scalar quantization or the vector quantization for the sub-bands; and performing the selected quantization, thereby making it possible to process real timely even when the throughput capacity for the vector quantization is insufficient.

It is a 29th object of the present invention to provide the sub-band adaptive differential pulse code modulation/ decoding method, wherein said preparing process of preparing said plural de-quantization means having: a quantization table storing unit for previously storing therein a vector quantization table that is used to vector-quantize said plural sub-band audio signals; a quantization table receiving unit for receiving the updated vector quantization table in response to the reception of a predetermined recognition signal which is indicative of the transmission of said vector quantization table; and decoding process return means for immediately returning to a decoding process of decoding said coded audio signal in response to the reception of a predetermined recognition signal which is indicative of the transmission of said coded audio signal when the transmission of said updated vector quantization table is interrupted, said plural de-quantizing processes further including: a quantization table storing process of making said quantization table storing unit store therein the vector quantization table that is used to vector-quantize said plural sub-band audio signals; a quantization table receiving process of making said quantization table receiving unit receive the updated vector quantization table in response to the reception of the predetermined recognition signal which is indicative of the transmission of said vector quantization table; and a decoding process return process of making said decoding process return means immediately return to the decoding process of decoding said coded audio signal in response to the reception of the predetermined recognition signal which is indicative of the transmission of said coded audio signal when the transmission of said updated vector quantization table is interrupted, and in said plural de-quantizing processes, said plural sub-band audio signals, respectively, are vector-de-quantized on the basis of said updated quantization table when the transmission of said updated quantization table is completed. According to the present invention, the sub-band adaptive differential pulse code modulation/decoding method comprises the preparing process of preparing a band division filter having a predetermined asymmetric impulse response, thereby making it possible to reduce a group delay due to the band filtering in comparison with that of the conventional band division filter having a symmetric impulse response. In the sub-band adaptive differential pulse code modulation/decoding method, each of the plural quantizing processes includes the steps of: learning a vector pattern adaptable to the vector pattern of the audio signal when the vector quantization is performed; updating the vector pattern stored in the vector quantization table; and transmitting, to the destination, the vector quantization table in which the updated vector pattern is stored, thereby rising a ratio of signal to noise.

It is a 29th object of the present invention to provide the sub-band adaptive differential pulse code modulation/ decoding method, wherein said preparing process of preparing said plural de-quantization means having: a quantization table storing unit for previously storing therein a vector quantization table that is used to vector-quantize said plural sub-band audio signals; a quantization table receiving unit for receiving the updated vector quantization table in response to the reception of a predetermined recognition signal which is indicative of the transmission of said vector quantization table; and decoding process return means for immediately returning to a decoding process of decoding said coded audio signal in response to the reception of a predetermined recognition signal which is indicative of the transmission of said coded audio signal when the transmission of said updated vector quantization table is interrupted, said plural de-quantizing processes further including: a quantization table storing process of making said quantization table storing unit store therein the vector quantization table that is used to vector-quantize said plural sub-band audio signals; a quantization table receiving process of making said quantization table receiving unit receive the updated vector quantization table in response to the reception of the predetermined recognition signal which is indicative of the transmission of said vector quantization table; and a decoding process return process of making said decoding process return means immediately return to the decoding process of decoding said coded audio signal in response to the reception of the predetermined recognition signal which is indicative of the transmission of said coded audio signal when the transmission of said updated vector quantization table is interrupted, and in said plural de-quantizing processes, said plural sub-band audio signals, respectively, are vector-de-quantized on the basis of said updated quantization table when the transmission of said updated quantization table is completed. According to the present invention, the sub-band adaptive differential pulse code modulation/decoding method comprises the preparing process of preparing a band division filter having a predetermined asymmetric impulse response, thereby making it possible to reduce a group delay due to the band filtering in comparison with that of the conventional band division filter having a symmetric impulse response. Even when the number of divided sub-bands increases, the sub-band adaptive differential pulse code modulation/decoding method can further reduce the scale of its hardware and a group delay due to the band filtering in comparison with those of the conventional band division filter having a tree structure.

It is a 30th object of the present invention to provide a wireless receiving system comprising: sub-band separating means for receiving a coded audio signal encoded from a plurality of sub-band audio signals including a plurality of sub-bands, and separating said plural sub-band coded audio signals from said coded audio signal; a plurality of de-quantization means for de-quantizing said plural sub-band coded audio signals with a predetermined number of sub-bands; and a plurality of band synthesizing means for band-synthesizing an audio signal from said de-quantized plural sub-band audio signals. According to the present invention, the wireless receiving system comprises a band division filter having a predetermined asymmetric impulse response, thereby making it possible to reduce a group delay due to the band filtering in comparison with that of the conventional band division filter having a symmetric impulse response. Even when the number of divided sub-bands increases, the wireless receiving system can further reduce the scale of its hardware and a group delay due to the band filtering in comparison with those of the conventional band division filter having a tree structure.

It is a 31st object of the present invention to provide the wireless receiving system, wherein said plural de-quantization means are operated to vector-quantize said plural sub-band audio signals, respectively. According to the present invention, the wireless receiving system comprises a band division filter having a predetermined asymmetric impulse response, thereby making it possible to reduce a group delay due to the band filtering in comparison with that of the conventional band division filter having a symmetric impulse response, and prevent a quality degradation of the audio signal decoded from the coded audio signal at a low bit rate.

It is a 32nd object of the present invention to provide the wireless receiving system, wherein said plural de-quantization means selectively operated to: vector-de-quantize the sub-band audio signals in the sub-bands in which the sub-band audio signals are previously designated to be vector-de-quantized; and scalar-de-quantize the sub-band audio signals in the sub-bands in which the sub-band audio signals are previously designated to be scalar-de-quantized. According to the present invention, the wireless receiving system comprises a band division filter having a predetermined asymmetric impulse response, thereby making it possible to reduce a group delay due to the band filtering in comparison with that of the conventional band division filter having a symmetric impulse response. The wireless receiving system is further operated to judge which should be performed the scalar quantization or the vector quantization for the sub-bands, to then perform the selected quantization, thereby making it possible to process real timely even when the wireless receiving system is insufficient in the throughput capacity for the vector quantization.

It is a 33rd object of the present invention to provide the wireless receiving system, wherein said plural de-quantization means have: a quantization table storing unit for previously storing therein a vector quantization table used to vector-quantize said plural sub-band audio signals; a quantization table receiving unit for receiving the updated vector quantization table in response to the reception of a predetermined recognition signal which is indicative of the transmission of said vector quantization table; and decoding process return means for immediately returning to a decoding process of decoding said coded audio signal in response to the reception of a predetermined recognition signal which is indicative of the transmission of said coded audio signal when the transmission of said updated vector quantization table is interrupted, said plural de-quantization means being operated to vector-de-quantize said plural sub-band audio signals, respectively, on the basis of said updated quantization table when the transmission of said quantization table is completed. According to the present invention, the wireless receiving system comprises a band division filter having a predetermined asymmetric impulse response, thereby making it possible to reduce a group delay due to the band filtering in comparison with that of the conventional band division filter having a symmetric impulse response. The wireless receiving system is further operated: to learn a vector pattern adaptable to the vector pattern of the audio signal when the vector quantization is performed; to update the vector pattern stored in the vector quantization table; and to then transmit, to the destination, the vector quantization table in which the updated vector pattern is stored, thereby rising a ratio of signal to noise.

Brief description of the drawings

The above feature and advantages of the sub-band ADPCM encoding apparatus, the sub-band ADPCM encoding method, the wireless transmission system, the sub-band ADPCM decoding apparatus, the sub-band ADPCM decoding method, and the wireless receiving system according to the present invention will be apparent from the following detailed description in conjunction with the accompanying drawings, in which:

FIG. 1 is a block diagram showing a first preferred embodiment of the sub-band adaptive differential pulse code modulation/encoding apparatus according to the present invention;
FIG. 2 is a block diagram showing the second preferred embodiment of the sub-band adaptive differential pulse code modulation/decoding apparatus according to the present invention;
FIG. 3 is a diagram showing an impulse response of the reference filter of the first embodiment according to the present invention;
FIG. 4 is a diagram showing frequency-amplitude characteristics of the reference filter of the first embodiment according to the present invention;
FIG. 5 is a diagram showing group delay characteristics of the reference filter of the first embodiment according to the present invention;

FIG. 6 is a diagram showing a list of coefficients of the reference filter of the first embodiment according to the present invention;
FIG.7 is a diagram showing a list of coefficients of the reference filter of the first embodiment according to the present invention;
FIG. 8 is a diagram showing a delay characteristic of the filter bank of the first embodiment according to the present invention different from that of the conventional filter bank;
FIG. 9 is a block diagram showing the first embodiment of the ADPCM quantizer according to the present invention for performing a vector quantization;
FIG. 10 is a block diagram showing the second embodiment of the ADPCM de-quantizer according to the present invention for performing a vector de-quantization;
FIG. 11 is a flowchart showing an operation of the sub-band ADPCM encoding apparatus 100;
FIG. 12 is a flowchart showing an operation of the ADPCM quantizers (110, 111, 112, and 113);
FIG. 13 is a flowchart showing an operation of updating a quantization table;
FIG. 14 is a flowchart showing an operation of the sub-band ADPCM decoding apparatus 200;
FIG. 15 is a flowchart showing an operation of the ADPCM de-quantizers (202, 203, 204, 205); and
FIG. 16 is a block diagram showing the conventional sub-band adaptive differential pulse code modulation/encoder and sub-band adaptive differential pulse code modulation/decoder.

Best mode of carrying out the present invention

The preferred embodiments of the present invention will be described hereinafter with reference to the drawings.

(A first preferred embodiment)

FIG. 1 is a block diagram showing a sub-band ADPCM encoding apparatus 100, as an example of the first embodiment of the sub-band ADPCM encoding apparatus according to the present invention, for dividing a predetermined frequency band into four sub-bands and encoding for the divided sub-bands. The sub-band ADPCM encoding apparatus 100 shown in FIG. 1 comprises: four band division finite impulse response filters, as referred to as simply "band division FIR filters" hereinlater, ($H_0$(z)102, $H_1$(z)103, $H_2$(z)104, and $H_3$(z)105), each having a predetermined asymmetric impulse response characteristic, for receiving an audio signal having a predetermined sampling frequency, and band-dividing the received audio signal into the predetermined four sub-bands; four down-samplers (106, 107, 108, and 109) for down-sampling the four sub-band audio signals for four predetermined sampling frequencies of the sub-bands to thin down the four sub-band audio signals, respectively; four quantizing means (110, 111, 112, and 113) for quantizing the down-sampled four sub-band audio signals, respectively, with a predetermined number of sub-bands; and encoding means (115) for performing adaptive differential pulse code modulation/encoding, referred to as simply "ADPCM encoding" hereinlater, the quantized four sub-band audio signals.

Furthermore, the band division FIR filters ($H_0$(z)102, $H_1$(z)103, $H_2$(z)104, and $H_3$(z)105) and four down-samplers (106, 107, 108, and 109) constitute a sub-band division filter bank 101. The sub-band division filter bank 101 further constitutes sub-band audio signal obtaining means. More specifically, each of the band division FIR filters ($H_0$(z)102, $H_1$(z)103, $H_2$(z)104, and $H_3$(z)105) comprises: a filter coefficient determining unit for determining a plurality of filter coefficients; and a filtering unit for filtering the predetermined sub-band audio signals from the audio signal on the basis of the determined filter coefficients, the filter coefficient determining unit being operated to perform a cosine-modulation with a predetermined phase difference with respect to an axis of symmetry of the symmetric finite impulse response, so that each of the band division FIR filters has a predetermined asymmetric impulse response.

The sub-band division filter bank 101 will be described hereinafter in further detail with reference to the drawings of FIGS. 3 through 7.

FIG. 3 is a graph showing the impulse response when the predetermined impulse signal is inputted to the band division FIR filters ($H_0$(z)102, $H_1$(z)103, $H_2$(z)104, and $H_3$(z)105). There is shown in FIG. 3 two waveforms of the impulse response. One of waveforms of the impulse response drawn by a one dot broken line is indicative of outputs of a symmetric impulse response with respect to a center of 64 samples obtained from predetermined plurality of filter coefficient signals. Another one of waveforms of the impulse response drawn by a solid line is indicative of outputs of an asymmetric impulse response obtained by modulating a plurality of predetermined filter coefficient signals inputted to a reference filter having a symmetric impulse response. There are shown in FIG. 6 and FIG. 7 lists indicative of an example for a plurality of predetermined filter coefficient signals inputted to the reference filter in the symmetric impulse response and the predetermined asymmetric impulse response.

As indicated by the following equation (1), an asymmetric impulse response cosine-modulated with a predetermined phase difference with respect to an axis of symmetry of the symmetric impulse response is referred to as "a predetermined asymmetric impulse response" herein. Furthermore, the filter coefficients of the band division FIR filters ($H_0(z)$102, $H_1(z)$103, $H_2(z)$104, and $H_3(z)$105) are determined, so as to have a predetermined asymmetric impulse response.

$$h_k(n) = 2p_L(n)\cos\left\{(2k+1)\frac{\pi}{2M}\left(n - \frac{k_d}{2}\right) - (2k+1)\frac{\pi}{4}\right\} \qquad \cdots(1)$$

where, ***k*** is the number of the sub-bands (0 to ***M***-1), $p_L(n)$ is the impulse response of the reference filter, ***M*** is the number of the sub-bands, $\boldsymbol{k_d}$ is a delay due to the division.

The frequency-amplitude characteristics shown in FIG. 4 are indicated that the amplitude of the filter having the asymmetric impulse response is further reduced in comparison with that of the filter having the symmetric impulse response. Moreover, the group delay characteristics shown in FIG. 5 are indicated that the group delay of the filter having the asymmetric impulse response is further reduced in comparison with that of the filter having the symmetric impulse response.

On one hand, the filter having the symmetric impulse response has ***N-1*** delays of the sub-band audio signals divided into the sub-bands; on the other hand, the filter having the predetermined asymmetric impulse response has the delays that are reduced to no more than ***N-1.*** Here, ***N*** is the number of taps of the reference filter.

The ADPCM quantizers (110, 111, 112, and 113) for performing the vector quantization will be described as the vector-quantization means hereinlater.

FIG. 9 shows the ADPCM quantizers (110, 111, 112, and 113) for vector-quantizing the audio signals.

The vector quantization is performed by selecting one vector having the least mean square error, which is obtained from a plurality of previously stored vectors used to quantize a predetermined number of samples as one vector, as a representative vector, and quantizing collectively a predetermined number of samples with the selected representative vector. The selected representative vector is referred to as a code vector. The plural representative vectors are previously collected and then stored on a table, which is referred to as a vector code book.

Moreover, the ADPCM quantizers (110, 111, 112, and 113) is designed to selectively operated to: vector-quantize the sub-band audio signals in the sub-bands in which the sub-band audio signals are previously designated to be vector-quantized; and scalar-quantize the sub-band audio signals in the sub-bands in which the sub-band audio signals are previously designated to be scalar-quantized. The sufficient throughput capacity for the vector quantization causes all of the sub-bands can be vector-quantized, regardless of the designation of the vector quantization; besides the insufficient throughput capacity for the vector quantization causes the sub-bands, only which are designated for the vector quantization, are vector-quantized.

The ADPCM quantizers (110, 111, 112, and 113) include: a quantization table storing unit 403 capable of previously storing, into a quantization table, a plurality of code vectors used to vector-quantize the plural sub-band audio signals, and a plurality of index numbers corresponding to the respective code vectors; a de-quantizer 404 for de-quantizing the code vectors stored in the quantization table storing unit; and a scale factor adaptor 405 for adapting a scale factor to the de-quantized code vector in accordance with the tendency of the variation of a plurality of previous code vectors. For instance, the scale factor adaptor 405 is operated to increase the scale factor when the variation of the previous code vectors shows a strong tendency; besides the scale factor adaptor 405 is operated to decrease the scale factor when the variation of the previous code vectors shows a weak tendency. The ADPCM quantizers (110, 111, 112, and 113) further includes: a predictor 406 for calculating a predictive value on the basis of a plurality of previous de-quantized values; an input buffer 401 for storing therein a plurality of sampled data on the sub-band audio signals for the next calculation; and a least mean square error calculator 402 for adding the de-quantized value de-quantized by the de-quantizer 404 and the predictive value calculated by the predictor 406 to obtain a predictive value of a plurality of sampled data on the next obtained sub-band audio signals, subtracting the predictive value of the plural sampled data on the next obtained sub-band audio signals from the sub-band audio signals stored in the input buffer 401, and calculating a least mean square error, so as to select one having the least error from the code vectors on the basis of the subtracted result.

The ADPCM quantizers (110, 111, 112, and 113) further comprises: quantization table updating unit for updating a vector quantization table by learning, by a predetermined learning method, the code vector capable of further reducing the error on the basis of the subtract result obtained by subtracting the predictive value of the plural sampled data on the next obtained sub-band audio signal from the plural sampled data on the sub-band audio signals stored in the input buffer 401; a state judging unit for judging whether the level of the inputted audio signal is no more than a predetermined minimum signal level or not, and judging whether the inputted audio signal is kept the predetermined minimum signal level or below over a predetermined duration or not; a quantization table transmitting unit for transmitting the updated quantization table to a predetermined destination. The quantization table transmitting unit is operated to transmit the updated quantization table to the predetermined destination when the state judging unit is operated to judge that the level of the inputted audio signal is no more than the predetermined minimum signal level, and judge that the inputted audio signal is kept the predetermined minimum signal level or below over the predetermined duration. The quantization table transmitting unit is operated to interrupt the transmission of the updated quantization table when the state judging unit is operated to judge that the level of the inputted audio signals exceeds the predetermined minimum signal level during the transmission of the updated quantization table for the destination. The quantization table transmitting unit is further operated to continuously transmit the updated quantization table when the state judging unit is operated to judge that the level of the inputted audio signal is no more than the predetermined minimum signal level, and judge that the inputted audio signal is kept the predetermined minimum signal level or below over the predetermined duration during the transmission of the updated quantization table for the destination. The ADPCM quantizers (110, 111, 112, and 113) are designed to perform the vector quantization on the basis of the updated quantization table when the transmission of the updated quantization table is completed.

The ADPCM quantizers (110, 111, 112, and 113) may further comprise a plurality of energy calculating units for each calculating an energy of the sub-band audio signal obtained by the de-quantization of the representative vector; a ratio calculating unit for calculating a ratio of the calculated energy of the plural sub-band audio signals; and an adaptive bit allocating unit for adaptively allocating the number of bits for the sub-bands on the basis of the ratio of the calculated energy of the plural sub-band audio signals, and be designed to allocate the number of bits for the sub-bands on the basis of the ratio of the energy of the de-quantized plural sub-band audio signals.

The adaptive bit allocator 114 is designed to adaptively allocate the bits for the sub-bands. The adaptive bit allocator 114 may be designed to allocate fixed bits instead of adaptive bit allocation for the sub-bands. The multiplexer 115 is designed to produce bit streams from the quantized audio signals for the sub-bands.

The operation of the sub-band ADPCM encoding apparatus 100 will be described hereinlater with reference to the drawings of FIG. 11.

The plural filter coefficient signals are previously designated to the band division FIR filters ($H_0(z)$102, $H_1(z)$103, $H_2(z)$104, and $H_3(z)$105), so that the plural band division FIR filters can have a predetermined asymmetric impulse response characteristic. Next, the audio is inputted and then converted to an audio signal (S101). The audio signal is then sampled at intervals of a predetermined frequency (S102). Next, in the band-dividing process, the inputted audio signal is divided into predetermined plural sub-bands by the sub-band audio signal obtaining means (S103). The sub-band audio signals are then down-sampled by the down-samplers (106, 107, 108, and 109) (S104). Next, in the quantization process, the band-divided plural sub-band audio signals are quantized with a predetermined number of sub-bands (S105). In the encoding process, the quantized plural sub-band audio signals are then adaptive differential pulse code modulation/encoded (S106).

The operation of the ADPCM quantizaters (110, 111, 112, and 113) will be described hereinafter with reference to the drawings in FIG. 12

Firstly, a plurality of sampled data on a plurality of sub-band audio signals for the next calculation are stored in the input buffer 401 (S201). The mean square error with the predictive value of the next plural sub-band audio signals are calculated by the least mean square error calculator 402. Then, the judgment is made whether the error is the least or not. When the judgment is made that the error is not the least, the following code vector is selected (S204). The selected code vector is then de-quantized by the de-quantizer 404 (S205). The scale factor is then adapted to the de-quantized code vector by the scale factor adaptor 405 (S206). The code vector adapted by the scale factor and the output of the predictor 406 are added. The mean square error with the sampled data of the next obtained sub-band audio signals are then calculated. The judgment is then made whether the mean square error is the least or not. When the judgment is made that the error is the least, the audio signal is vector-quantized on the basis of the code vector.

The operation of the updation of the quantization table will be described hereinlater with reference to the drawings in FIG. 13.

The quantization table is updated by the learning, and then the judgment is made whether the updated quantization table is transmitted or not (S301). Next, the judgment is made, by the state judging unit, whether the signal level is no more than a predetermined minimum signal level or not, and then the judgment is made whether the signal is kept the predetermined minimum signal level or below over a predetermined duration or not (S302). The updated quantization table is then transmitted to a predetermined destination by the quantization table transmitting unit (S303). When the judgment is made, by the state judging unit, that the signal level of the inputted audio signal exceeds the predetermined minimum signal level, in the middle of the transmission of the updated vector quantization table for the destination, the quantization table transmitting unit is operated to interrupt the transmission of the updated vector quantization table (S304). When the judgment is made, by the state judging unit, that the signal level is no more than the predetermined minimum signal level, and that the signal is kept the predetermined minimum signal level or below for the predetermined duration, the quantization table transmitting unit is operated to continuously transmit the updated vector quantization table. The completion of the transmission of the updated quantization table causes: the transmitting end to perform the vector quantization on the basis of the updated vector quantization table; but the receiving end to perform the vector de-quantization on the basis of the updated vector quantization table.

The above sub-band ADPCM encoding apparatus is thus described as one example that the audio signal is divided into, but not limited to, four bands.

As described above, the preferred embodiment according to the present invention can provide the sub-band ADPCM encoding apparatus comprising band-divided filters each having an asymmetric impulse response characteristic, thereby causing a little group delay.

(A second preferred embodiment)

FIG. 2 is a block diagram showing a sub-band ADPCM decoding apparatus 200, as an example of the second preferred embodiment of the sub-band ADPCM decoding apparatus according to the present invention, for decoding an audio signal from the coded audio signal obtained by dividing a predetermined frequency into four sub-bands and encoding. The sub-band ADPCM decoding apparatus 200 shown in FIG. 2 comprises: de-multiplexer 201 for separating four sub-band coded audio signals for a predetermined number of bits from a coded audio signal having four sub-band coded audio signals which are obtained by encoding the audio signals and dividing the coded audio signals into four sub-bands; four de-quantizing means (202, 203, 204, and 205) for de-quantizing the separated four sub-band coded audio signals with a predetermined number of sub-bands; the quantized four sub-band audio signals having sampling frequencies of the sub-bands down-sampled so as to thin down the sampled values on the sub-band audio signals, respectively, four up-samplers (207, 208, 209, and 210) for up-sampling the sub-band audio signals so as to interpolate the thinned down sampled values on the sub-band audio signals, the up-sampled four sub-band audio signals having the sub-band audio components of the audio, respectively; four band synthesis filters ($F_0$(z)211, $F_1$(z)212, $F_2$(z)213, and $F_3$(z)214) for receiving the four sub-band audio signals and a plurality of predetermined filter coefficients, and synthesizing the audio signal from the received four sub-band audio signals; and four filter coefficient determining means for determining a plurality of predetermined filter coefficients used to be inputted to the four band synthesis filters ($F_0$(z)211, $F_1$(z)212, $F_2$(z)213, and $F_3$(z)214), respectively, so that each of the four band synthesis filters has a predetermined asymmetric impulse response characteristic.

The band synthesis FIR filters ($F_0$(z)211, $F_1$(z)212, $F_2$(z)213, and $F_3$(z)214) further comprise: a filter coefficient determining unit for determining a plurality of filter coefficients; and a filtering unit for synthesizing a predetermined sub-band audio signals from the audio signal on the basis of the determined filter coefficients, and are operated to perform a cosine-modulation with a predetermined phase difference with respect to an axis of symmetry of the symmetric finite impulse response, so that each of the band synthesis filters has a predetermined asymmetric impulse response.

As indicated by the following equation (2), the plurality of predetermined filter coefficients are designated so as to modulate an impulse response with a predetermined cosine signal.

$$f_k(n) = 2p_L(n)\cos\left\{(2k+1)\frac{\pi}{2M}\left(n-\frac{k_d}{2}\right)+(2k+1)\frac{\pi}{4}\right\} \quad \cdots (2)$$

where, ***k*** is the number of the sub-bands (0 to ***M***-1), $\boldsymbol{p_L(n)}$ is the impulse response of the reference filter, ***M*** is the number of the sub-bands, $\boldsymbol{k_d}$ is a delay due to the division.

FIG. 8 shows the delay of the filter bank having the asymmetric impulse response characteristic of the preferred embodiment according to the present invention in comparison with that of the conventional filter band having a tree structure. It is apparent from FIG. 8 that the sub-band encoding-decoding method of the preferred embodiment according to the present invention has achieved a magnificent effect of the reduction in delay.

FIG. 10 shows the ADPCM de-quantizers (202, 203, 204, and 205) for vector-quantizing for one of the sub-bands. As shown in FIG. 10, the ADPCM de-quantizers (202, 203, 204, and 205) comprises: a vector code book 501 for calculating a code vector on the basis of the received index number; de-quantizer 502 for de-quantizing the code vector; a scale factor adaptor 503 for calculating a scale factor for the de-quantization; and a predictor 504.

The insufficient throughput capacity for the vector quantization in real time operation may cause the ADPCM to perform a general scalar quantization for some sub-bands. At the side of the encoding unit, the sufficient throughput capacity in real time operation allows that the code vector to be learned to update the vector code book.

The operation of the sub-band ADPCM decoding apparatus 200 will be described hereinlater with reference to the drawings of FIG. 14.

The index number of the code vector is received and the code vector corresponding to the received index number is selected from among the vector code book 501 (S401). The selected code vector is then de-quantized for the sub-bands by the ADPCM de-quantizers (202, 203, 204, and 205), respectively, to obtain the audio signal (S402). The de-quantized audio signal is up-sampled for the sub-bands by the up-samplers (207, 208, 209, and 210) (S403). The up-sampled audio signal is then synthesized into the audio signal by way of the band synthesis filter (211, 212, 213, and 214) (S404).

The operation of the ADPCM de-quantizers (202, 203, 204, and 205) will be described hereinlater with reference to the drawings of FIG. 15.

Firstly, the index number of the code vector is received (S501). The code vector corresponding to the index number is then selected (S502). The selected code vector is then de-quantized by the de-quantizer 502, the scale factor is adapted by the scale factor adaptor 503 (S504). The output of the predictor 504 is added and then outputted from the ADPCM de-quantizers (S505).

The operation of the reception of the updated quantization table will be described herein.

When the judgment is made that no signal is inputted to the side of the encoder, a normally unallocated index number is prepared. Just before the updated vector code book is transmitted to the decoder, this index number is transmitted for a predetermined duration. After that, the updated vector code book is transmitted. There is any input signal in the middle of the transmission; the normal encoding index is transmitted after the transmission of the normally unallocated index number is completed so that the transmission of the updated vector code book is immediately interrupted. When the encoder becomes no input state again, the normally unallocated index number is transmitted for a predetermined duration. After that, the transmission of the updated vector code book is resumed from the position interrupted. After the transmission of a predetermined vector code books is completed, the normal encoding process and decoding process are resumed.

The above sub-band ADPCM decoding apparatus is thus described as one example that the audio signal is divided into, but not limited to, four bands.

As described above, the present invention can provide the sub-band ADPCM encoding apparatus, the sub-band ADPCM encoding method, and the wireless transmission system which includes a coefficient determining means for determining a plurality of filter coefficients to make the band division filter and the band synthesis filter have asymmetric impulse response characteristics, thereby reducing a group delay in comparison with that of the conventional band division filter and the band synthesis filter having a symmetric impulse response.

The present invention can further provide the sub-band ADPCM decoding apparatus, the sub-band decoding method, and the wireless receiving system which comprises: a separating unit for receiving a coded audio signal, and separating a plurality of sub-bands each having a predetermined number of bits for frames; a de-quantizing unit for de-quantizing the separated signals, respectively, with a predetermined number of sub-bands; and a synthesis filter bank for synthesizing the respective de-quantized signals, thereby making it possible to reduce the group delay due to the filtering in comparison with that of the conventional reference filter which has a symmetric impulse response. When the number of divided sub-bands increases, the present invention can further provide the sub-band ADPCM decoding apparatus, the sub-band decoding method, and the wireless receiving system, which can have an effect in the reduction in the scale of its hardware and the group delay in comparison with those having a tree structure.

## Claims

**1.** A sub-band adaptive differential pulse code modulation/encoding apparatus comprising:

> sub-band audio signal obtaining means having a predetermined asymmetric impulse response for receiving an audio signal and band-dividing the received audio signal into a predetermined number of sub-bands, so as to obtain a plurality of band-divided sub-band audio signals;
> a plurality of quantization means for quantizing said band-divided sub-band audio signals with the predetermined number of sub-bands; and
> encoding means for performing adaptive differential pulse code modulation/encoding the quantized sub-band audio signals.

**2.** The sub-band adaptive differential pulse code modulation/encoding apparatus as set forth in claim 1, wherein said plural quantization means are operated to vector-quantize said plural sub-band audio signals, respectively.

**3.** The sub-band adaptive differential pulse code modulation/encoding apparatus as set forth in claim 1, wherein said plural quantization means are selectively operated to: vector-quantize the sub-band audio signals in the sub-bands in which the sub-band audio signals are previously designated to be vector-quantized; and scalar-quantize the sub-band audio signals in the sub-bands in which the sub-band audio signals are previously designated to be scalar-quantized.

**4.** The sub-band adaptive differential pulse code modulation/encoding apparatus as set forth in claim 2 or 3, wherein said plural quantization means have:

a quantization table storing unit for previously storing, into a quantization table, a plurality of code vectors used to vector-quantize said plural sub-band audio signals;
a quantization table updation unit for updating said previously stored plural code vectors on the basis of a signal pattern of said plural sub-band audio signals; and
a quantization table transmitting unit for judging whether a silent state, in which the level of said received audio signal is less than a predetermined minimum signal level, is kept over a predetermine duration or not, and transmitting said updated quantization table on the basis of the judgment result,
said plural quantization means being operated to vector-quantize said plural sub-band audio signals, respectively, on the basis of said updated quantization table when the transmission of said updated quantization table is completed.

**5.** The sub-band adaptive differential pulse code modulation/encoding apparatus as set forth in claim 1, wherein said sub-band audio signal obtaining means includes a plurality of band division filters each having an asymmetric finite impulse response, and said plural band division filters being operated to band-divide said audio signal into said plural predetermined sub-bands.

**6.** The sub-band adaptive differential pulse code modulation/encoding apparatus as set forth in claim 5, said band division filters respectively include: a filter coefficient determining unit for determining a plurality of filter coefficients; and a filtering unit for filtering a predetermined sub-band audio signal from said audio signal on the basis of said determined filter coefficients, and said filter coefficient determining unit being operated to perform a cosine-modulation with a predetermined phase difference with respect to an axis of symmetry of the symmetric finite impulse response, and to determine said plural filter coefficients, so that each of the band division filters has a predetermined asymmetric impulse response.

**7.** A sub-band adaptive differential pulse code modulation/encoding apparatus comprising:

a microphone for inputting an audio and converting the inputted audio into an audio signal;
discrete audio signal obtaining means for sampling said converted audio signal at predetermined intervals, so as to obtain a discrete audio signal;
sub-band audio signal obtaining means having a predetermined asymmetric impulse response for receiving an audio signal and band division the received audio signal into a predetermined number of sub-bands, so as to obtain a plurality of band-divided sub-band discrete audio signals;
a plurality of down-samplers for down-sampling said band-divided sub-band discrete audio signals for a predetermined sampling frequencies of said plural sub-bands to thin down said divided sub-band discrete audio signals
a plurality of quantization means for vector-quantizing said down-sampled sub-band discrete audio signals with the predetermined of sub-bands; and
encoding means for performing adaptive differential pulse code modulation/encoding the quantized sub-band audio signals.

**8.** The sub-band adaptive differential pulse code modulation/encoding apparatus as set forth in claim 7, wherein said plural quantization means include:

a quantization table storing unit for previously storing, into a quantization table, a plurality of code vectors used to vector-quantize said respective plural sub-band audio signals, and a plurality of index numbers corresponding to said respective code vectors;
a de-quantizer for de-quantizing the code vectors stored in said quantization table storing unit;
a scale factor adaptor for adapting a scale factor to the de-quantized code vector in accordance with the tendency of the variation of a plurality of previous code vectors, said scale factor adaptor being operated to increase the scale factor when the variation of the previous code vectors shows a strong tendency, said scale factor adaptor being operated to decrease the scale factor when the variation of the previous code vectors shows a weak tendency;
a predictor for calculating a predictive value on the basis of a plurality of previous de-quantized values;
an input buffer for storing therein a plurality of sampled data on the sub-band audio signals for the next calculation; and

a least mean square error calculator for adding the de-quantized value de-quantized by said de-quantizer and the predictive value calculated by said predictor to obtain a predictive value of the next obtained sub-band audio signals, subtracting said predictive value of the next obtained sub-band audio signals from said sub-band audio signals stored in said input buffer, and calculating a least mean square error, so as to select one having the least error from the code vectors on the basis of the subtracted result,
said least mean square error calculator being operated to select one code vector from among said plural code vectors stored in said quantization table storing unit, and
said plural quantization means performing a vector-quantize on the basis of said selected one code vector.

**9.** The sub-band adaptive differential pulse code modulation/encoding apparatus as set forth in claim 7, wherein said plural quantization means include:

a quantization table updating unit for updating a vector quantization table by learning, by a predetermined learning method, the code vector capable of further reducing the error on the basis of the subtracted result obtained by subtracting the predictive value of the plural sampled data on the next obtained sub-band audio signal from the plural sampled data on said sub-band audio signals stored in said input buffer;
a state judging unit for judging whether the level of said received audio signal is no more than a predetermined minimum signal level or not, and further judging whether the received audio signal is kept said predetermined minimum signal level or below over a predetermined duration or not; and
a quantization table transmitting unit for transmitting said updated quantization table to a predetermined destination,
said quantization table transmitting unit being operated to transmit said updated quantization table to the predetermined destination when said state judging unit is operated to judge that the level of said received audio signal is no more than the predetermined minimum signal level, and judge that said received audio signal is kept said predetermined minimum signal level or below over the predetermined duration,
said quantization table transmitting unit being operated to interrupt the transmission of said updated quantization table when said state judging unit is operated to judge that the level of said received audio signals exceeds the predetermined minimum signal level during the transmission of said updated quantization table for the destination,
said quantization table transmitting unit being further operated to resume transmitting said updated quantization table when said state judging unit is operated to judge that the level of said received audio signal is no more than the predetermined minimum signal level, and judge that the inputted audio signal is kept said predetermined minimum signal level or below over the predetermined duration during the transmission of the updated quantization table for the destination,
said plural quantizers being operated to perform the vector quantization on the basis of said updated quantization table when the transmission of said updated quantization table is completed.

**10.** The sub-band adaptive differential pulse code modulation/encoding apparatus as set forth in claim 7, wherein said vector quantization means is operated to calculate an energy of said plural sub-band audio signals de-quantized by said de-quantizer, and to adaptively allocate the number of bits on the basis of the ratio of the energy of said calculated plural sub-band audio signals.

**11.** A sub-band adaptive differential pulse code modulation/encoding method comprising:

a preparing process of preparing a plurality of sub-band audio signal obtaining means having a predetermined asymmetric impulse response for receiving an audio signal and band-dividing the received audio signal into a predetermined number of sub-bands, so as to obtain a plurality of band-divided sub-band audio signals, a plurality of quantization means for quantizing said band-divided sub-band audio signals with the predetermined number of sub-bands, and encoding means for performing adaptive differential pulse code modulation/encoding said quantized sub-band audio signals;
a plurality of sub-bands audio signal obtaining processes of making said band division filter band-divide said received audio signal into said predetermined number of sub-bands, so as to obtain said plural band-divided sub-band audio signals, respectively;
a plurality of quantizing processes of making said plural quantization means respectively quantize said band-divided sub-band audio signals with the predetermined number of sub-bands; and
an encoding process of performing adaptive differential pulse code modulation/encoding said quantized plural sub-band audio signals by said plurality of quantization means.

**12.** The sub-band adaptive differential pulse code modulation/encoding method as set forth in claim 11, wherein said plurality of quantization processes of respectively making said plural quantization means vector-quantize said plural sub-band audio signals.

**13.** The sub-band adaptive differential pulse code modulation/encoding method as set forth in claim 11, wherein said plurality of quantization processes of: selectively performing the vector-quantization of the sub-band audio signals in the sub-bands in which the sub-band audio signals are previously designated to be vector-quantized; and performing scalar-quantization of the sub-band audio signals in the sub-bands in which the sub-band audio signals are previously designated to be scalar-quantized.

**14.** The sub-band adaptive differential pulse code modulation/encoding method as set forth in claim 12 or 13, wherein said preparing process of preparing said plural quantization means having:

a quantization table storing unit for previously storing, into a quantization table, a plurality of code vectors used to vector-quantize said plural sub-band audio signals;
a quantization table updation unit for updating said previously stored plural code vectors on the basis of a signal pattern of said plural sub-band audio signals; and
a quantization table transmitting unit for judging whether a silent state, in which the level of said received audio signal is less than a predetermined minimum signal level, is kept over a predetermine duration or not, and transmitting said updated quantization table on the basis of the judgment result,
said plural quantizing processes further including:

a quantization table storing process of previously storing, into a quantization table, a plurality of code vectors used to vector-quantize said plural sub-band audio signals;
a quantization table updation process of updating said previously stored plural code vectors on the basis of a signal pattern of said plural sub-band audio signals; and
a quantization table transmitting process of judging whether a silent state, in which the level of said received audio signal is less than a predetermined minimum signal level, is kept over a predetermine duration or not, and transmitting said updated quantization table on the basis of the judgment result,
in said plural quantizing processes, said plural sub-band audio signals, respectively, are vector-quantized on the basis of said updated quantization table when the transmission of said updated quantization table is completed.

**15.** A wireless transmission system comprising:

sub-band audio signal obtaining means having a predetermined asymmetric impulse response for receiving an audio signal and band-dividing the received audio signal into a predetermined number of sub-bands, so as to obtain a plurality of band-divided sub-band audio signals;
a plurality of quantization means for quantizing said band-divided sub-band audio signals with the predetermined number of sub-bands; and
encoding means for performing adaptive differential pulse code modulation/encoding the quantized sub-band audio signals.

**16.** The wireless transmission system as set forth in claim 15, wherein said plural quantization means are operated to vector-quantize said plural sub-band audio signals, respectively.

**17.** The wireless transmission system as set forth in claim 15, wherein said plural quantization means are selectively operated to: vector-quantize the sub-band audio signals in the sub-bands in which the sub-band audio signals are previously designated to be vector-quantized; and scalar-quantize the sub-band audio signals in the sub-bands in which the sub-band audio signals are previously designated to be scalar-quantized.

**18.** The wireless transmission system as set forth in claim 16 or 17, wherein said plural quantization means have:

a quantization table storing unit for previously storing, into a quantization table, a plurality of code vectors used to vector-quantize said plural sub-band audio signals;
a quantization table updation unit for updating said previously stored plural code vectors on the basis of a signal pattern of said plural sub-band audio signals; and
a quantization table transmitting unit for judging whether a silent state, in which the level of said received audio signal is less than a predetermined minimum signal level, is kept over a predetermine duration or not, and transmitting said updated quantization table on the basis of the judgment result,
said plural quantization means being operated to vector-quantize said plural sub-band audio signals, respectively, on the basis of said updated quantization table when the transmission of said updated quantization table is completed.

**19.** A sub-band adaptive differential pulse code modulation/decoding apparatus comprising:

sub-band separating means for receiving a coded audio signal encoded from a plurality of sub-band audio signals including a plurality of sub-bands, and separating said plural sub-band coded audio signals from said coded audio signal;
a plurality of de-quantization means for de-quantizing said plural sub-band coded audio signals with a predetermined number of sub-bands; and
a plurality of band synthesizing means for band-synthesizing an audio signal from said de-quantized plural sub-band audio signals.

**20.** The sub-band adaptive differential pulse code modulation/decoding apparatus as set forth in claim 19, wherein said plural de-quantization means are operated to vector-de-quantize said plural sub-band audio signals, respectively.

**21.** The sub-band adaptive differential pulse code modulation/decoding apparatus as set forth in claim 19, wherein said plural de-quantization means selectively operated to: vector-de-quantize the sub-band audio signals in the sub-bands in which the sub-band audio signals are previously designated to be vector-de-quantized; and scalar-de-quantize the sub-band audio signals in the sub-bands in which the sub-band audio signals are previously designated to be scalar-de-quantized.

**22.** The sub-band adaptive differential pulse code modulation/decoding apparatus as set forth in claim 20 or 21, wherein said plural de-quantization means have:

a quantization table storing unit for previously storing therein a vector quantization table that is the same vector quantization table that is obtained by vector-quantizing said plural sub-band audio signals;
a quantization table receiving unit for receiving the updated vector quantization table in response to the reception of a predetermined recognition signal which is indicative of the transmission of said vector quantization table; and
decoding process return means for immediately returning to a decoding process of decoding said coded audio signal in response to the reception of a predetermined recognition signal which is indicative of the transmission of said coded audio signal when the transmission of said updated vector quantization table is interrupted,
said plural de-quantization means being operated to vector-de-quantize said plural sub-band audio signals, respectively, on the basis of said updated quantization table when the transmission of said quantization table is completed.

**23.** The sub-band adaptive differential pulse code modulation/decoding apparatus as set forth in claim 19, wherein said band synthesizing means includes: a band synthesis unit having a predetermined asymmetric finite impulse response; and a filter coefficient determining unit for determining a plurality of filter coefficients,
said filter coefficient determining unit being operated to perform a cosine-modulation with a predetermined phase difference with respect to an axis of symmetry of the symmetric finite impulse response, and to determine said plural filter coefficients, so that each of the band synthesis means has a predetermined asymmetric impulse response.

**24.** A sub-band adaptive differential pulse code modulation/decoding apparatus comprising:

a sub-band separating means for receiving a plurality of sub-band audio signals, for a plurality of sub-bands, encoded from a plurality of audio signals of said plural sub-bands, and separating a plurality of index numbers respectively corresponding to a plurality of code vectors which is used to vector-quantize said plural sub-band coded audio signals to obtain said plural sub-band audio signals;
a plurality of de-quantization means for vector-de-quantizing to obtain said plural sub-band audio signals on the basis of the separated index numbers;
an up-sampler for up-sampling for up-sampling said predetermined plural sub-band audio signals so as to interpolate the thinned down sampled values into the plural sub-band audio signals down-sampled for thinning down; and

a band synthesizing means for band-synthesizing said audio signal from said sub-band audio components having said plural sub-band audio signals.

**25.** The sub-band adaptive differential pulse code modulation/decoding apparatus as set forth in claim 24, wherein said plural de-quantization means have:

a quantization table storing unit for previously storing therein a vector quantization table that is the same vector quantization table that is obtained by vector-quantizing said plural sub-band audio signals;

a plurality of de-quantization means for retrieving a plurality of code vectors from said quantization table storing unit on the basis of said separated index numbers and de-quantizing said retrieved plural code vector, respectively;

a scale factor adaptor for adapting a scale factor to the de-quantized code vector in accordance with the tendency of the variation of a plurality of previous code vectors, said scale factor adaptor being operated to increase the scale factor when the variation of the previous code vectors shows a strong tendency, said scale factor adaptor being operated to decrease the scale factor when the variation of the previous code vectors shows a weak tendency;

a predictor for calculating a predictive value on the basis of a plurality of previous de-quantized values; and

said plural de-quantization means being operated to retrieve said stored plural code vectors from said quantization table on the basis of said plural index numbers, and to de-quantize on the basis of said plural code vectors, respectively.

**26.** A sub-band adaptive differential pulse code modulation/decoding method comprising:

a preparing process of preparing sub-band separating means for receiving a coded audio signal encoded from a plurality of sub-band audio signals including a plurality of sub-bands, and separating said plural sub-band coded audio signals from said coded audio signal,

a plurality of de-quantization means for de-quantizing said plural sub-band coded audio signals with a predetermined number of sub-bands, and

band synthesizing means for band-synthesizing an audio signal from said de-quantized plural sub-band audio signals;

a sub-band separating process of receiving a coded audio signal encoded from a plurality of sub-band audio signals including a plurality of sub-bands, and making said sub-band separating means separate said plural sub-band coded audio signals from said coded audio signal,

a plurality of de-quantizing processes of making said plural de-quantization means respectively de-quantize said plural sub-band coded audio signals with the predetermined number of sub-bands; and

band synthesizing process of making said synthesizing means band-synthesize said audio signals from said de-quantized plural sub-band audio signals.

**27.** The sub-band adaptive differential pulse code modulation/decoding method as set forth in claim 26, wherein said plural de-quantizing processes of respectively making said plural de-quantization means vector-quantize said separated plural sub-band audio signals.

**28.** The sub-band adaptive differential pulse code modulation/decoding method as set forth in claim 26, wherein said plural de-quantizing processes of: selectively making said de-quantization means vector-quantize the sub-band audio signals in the sub-bands in which the sub-band audio signals are previously designated to be vector-de-quantized; and making said de-quantization means scalar-quantize the sub-band audio signals in the sub-bands in which the sub-band audio signals are previously designated to be scalar-de-quantized.

**29.** The sub-band adaptive differential pulse code modulation/decoding method as set forth in claim 27 or 28, wherein said preparing process of preparing said plural de-quantization means having:

a quantization table storing unit for previously storing therein a vector quantization table that is used to vector-quantize said plural sub-band audio signals;

a quantization table receiving unit for receiving the updated vector quantization table in response to the reception of a predetermined recognition signal which is indicative of the transmission of said vector quantization table; and

decoding process return means for immediately returning to a decoding process of decoding said coded audio signal in response to the reception of a predetermined recognition signal which is indicative of the transmission of said coded audio signal when the transmission of said updated vector quantization table is interrupted, said plural de-quantizing processes further including:

a quantization table storing process of making said quantization table storing unit store therein the vector quantization table that is used to vector-quantize said plural sub-band audio signals;
a quantization table receiving process of making said quantization table receiving unit receive the updated vector quantization table in response to the reception of the predetermined recognition signal which is indicative of the transmission of said vector quantization table; and
a decoding process return process of making said decoding process return means immediately return to the decoding process of decoding said coded audio signal in response to the reception of the predetermined recognition signal which is indicative of the transmission of said coded audio signal when the transmission of said updated vector quantization table is interrupted, and
in said plural de-quantizing processes, said plural sub-band audio signals, respectively, are vector-de-quantized on the basis of said updated quantization table when the transmission of said updated quantization table is completed.

**30.** A wireless receiving system comprising:

sub-band separating means for receiving a coded audio signal encoded from a plurality of sub-band audio signals including a plurality of sub-bands, and separating said plural sub-band coded audio signals from said coded audio signal;
a plurality of de-quantization means for de-quantizing said plural sub-band coded audio signals with a predetermined number of sub-bands; and
a plurality of band synthesizing means for band-synthesizing an audio signal from said de-quantized plural sub-band audio signals.

**31.** The wireless receiving system as set forth in claim 30, wherein said plural de-quantization means are operated to vector-de-quantize said plural sub-band audio signals, respectively.

**32.** The wireless receiving system as set forth in claim 30, wherein said plural de-quantization means selectively operated to: vector-de-quantize the sub-band audio signals in the sub-bands in which the sub-band audio signals are previously designated to be vector-de-quantized; and scalar-de-quantize the sub-band audio signals in the sub-bands in which the sub-band audio signals are previously designated to be scalar-de-quantized.

**33.** The wireless receiving system as set forth in claim 31 or 32, wherein said plural de-quantization means have:

a quantization table storing unit for previously storing therein a vector quantization table used to vector-quantize said plural sub-band audio signals;
a quantization table receiving unit for receiving the updated vector quantization table in response to the reception of a predetermined recognition signal which is indicative of the transmission of said vector quantization table; and
decoding process return means for immediately returning to a decoding process of decoding said coded audio signal in response to the reception of a predetermined recognition signal which is indicative of the transmission of said coded audio signal when the transmission of said updated vector quantization table is interrupted,
said plural de-quantization means being operated to vector-de-quantize said plural sub-band audio signals, respectively, on the basis of said updated quantization table when the transmission of said quantization table is completed.

F I G. 1

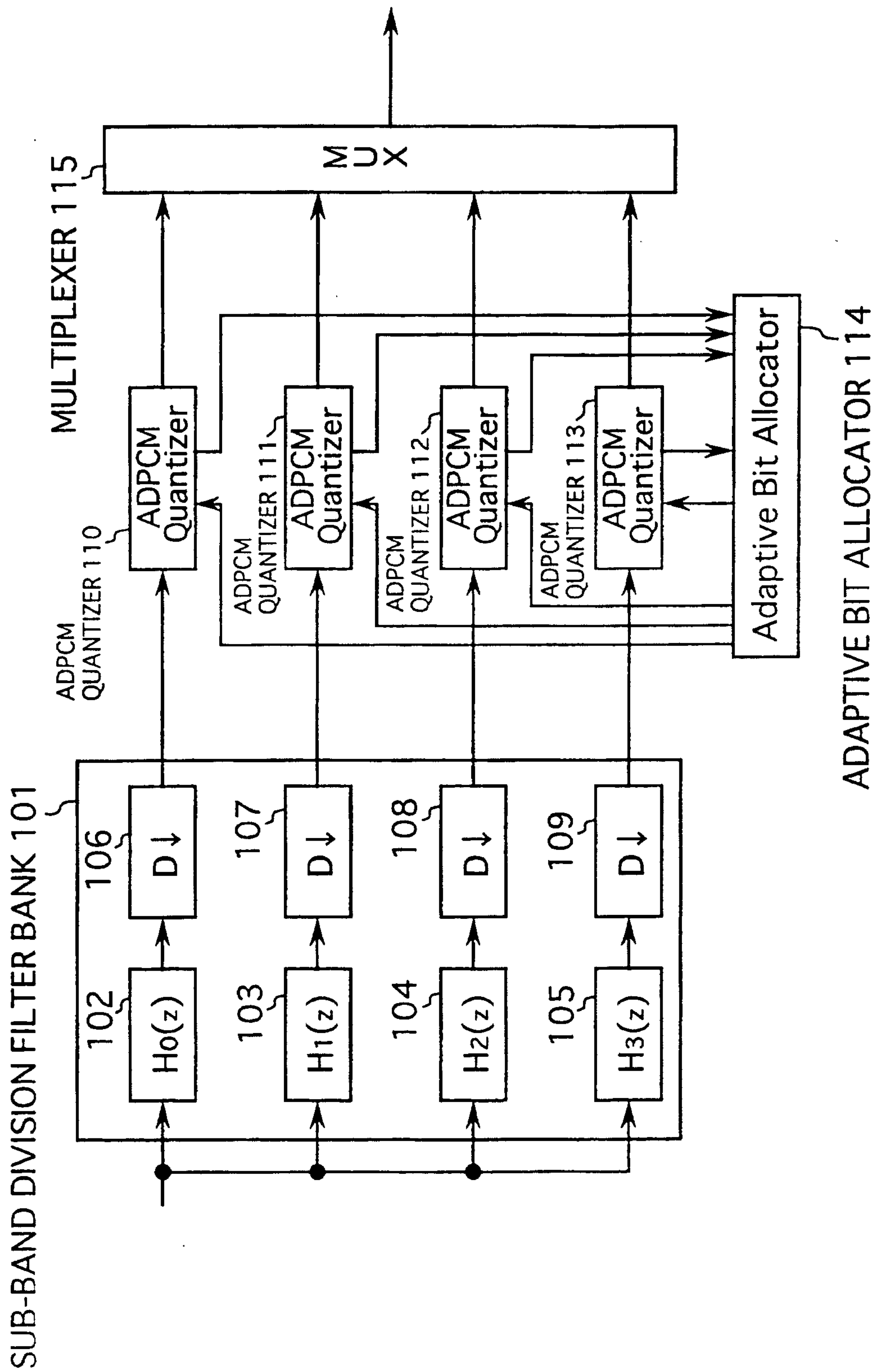
SUB-BAND DIVISION FILTER BANK 101
102
Ho(z)
103
H1(z)
104
H2(z)
105
H3(z)
106
D↓
107
D↓
108
D↓
109
D↓
ADPCM QUANTIZER 110
ADPCM Quantizer
ADPCM QUANTIZER 111
ADPCM Quantizer
ADPCM QUANTIZER 112
ADPCM Quantizer
ADPCM QUANTIZER 113
ADPCM Quantizer
Adaptive Bit Allocator
ADAPTIVE BIT ALLOCATOR 114
MULTIPLEXER 115
MUX

FIG. 2

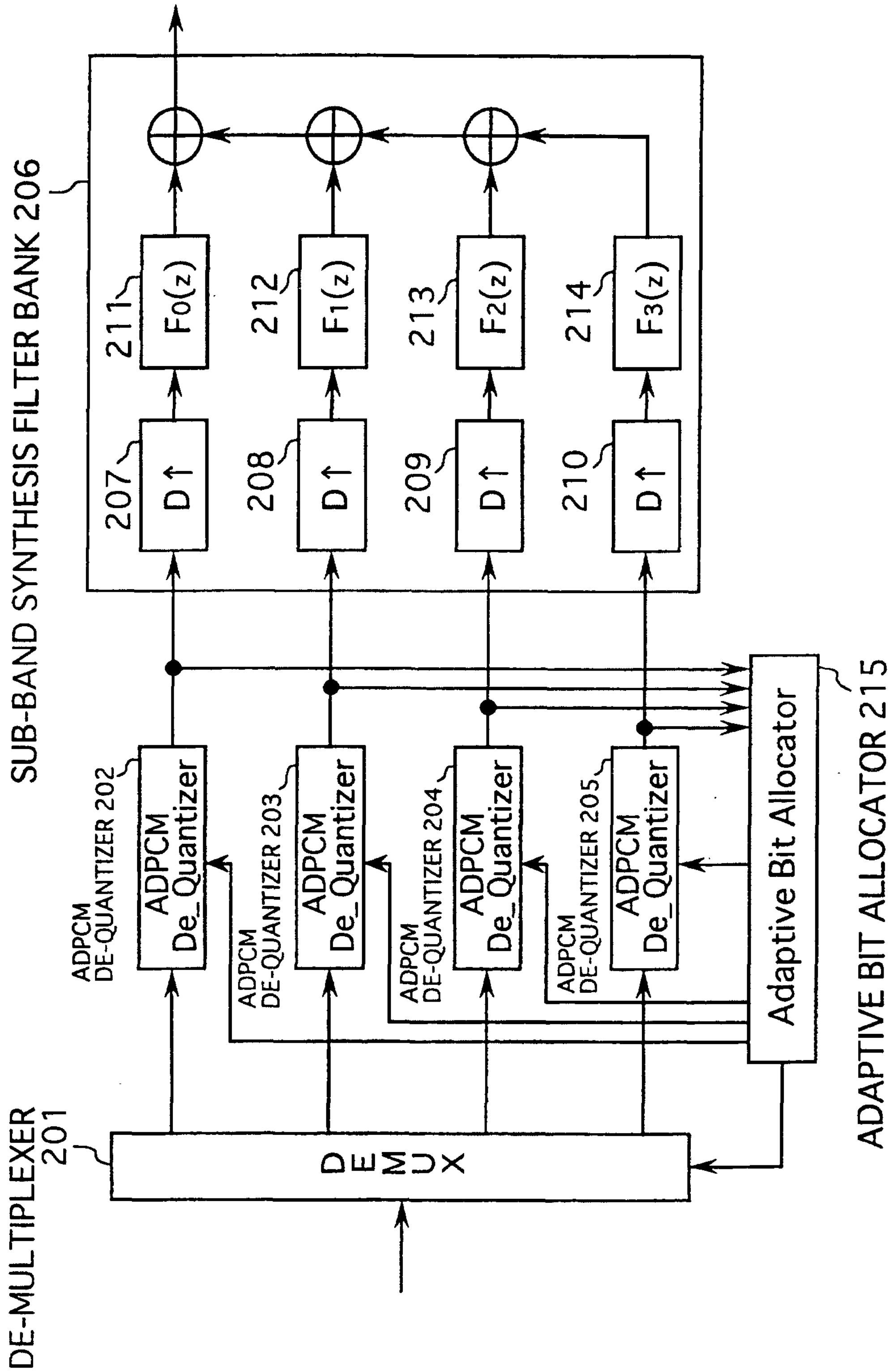
SUB-BAND SYNTHESIS FILTER BANK 206
DE-MULTIPLEXER 201
DEMUX
ADPCM DE-QUANTIZER 202
ADPCM DE-QUANTIZER 203
ADPCM DE-QUANTIZER 204
ADPCM DE-QUANTIZER 205
ADPCM De_Quantizer
207
208
209
210
D↑
211
212
213
214
F0(z)
F1(z)
F2(z)
F3(z)
Adaptive Bit Allocator
ADAPTIVE BIT ALLOCATOR 215

F I G. 3

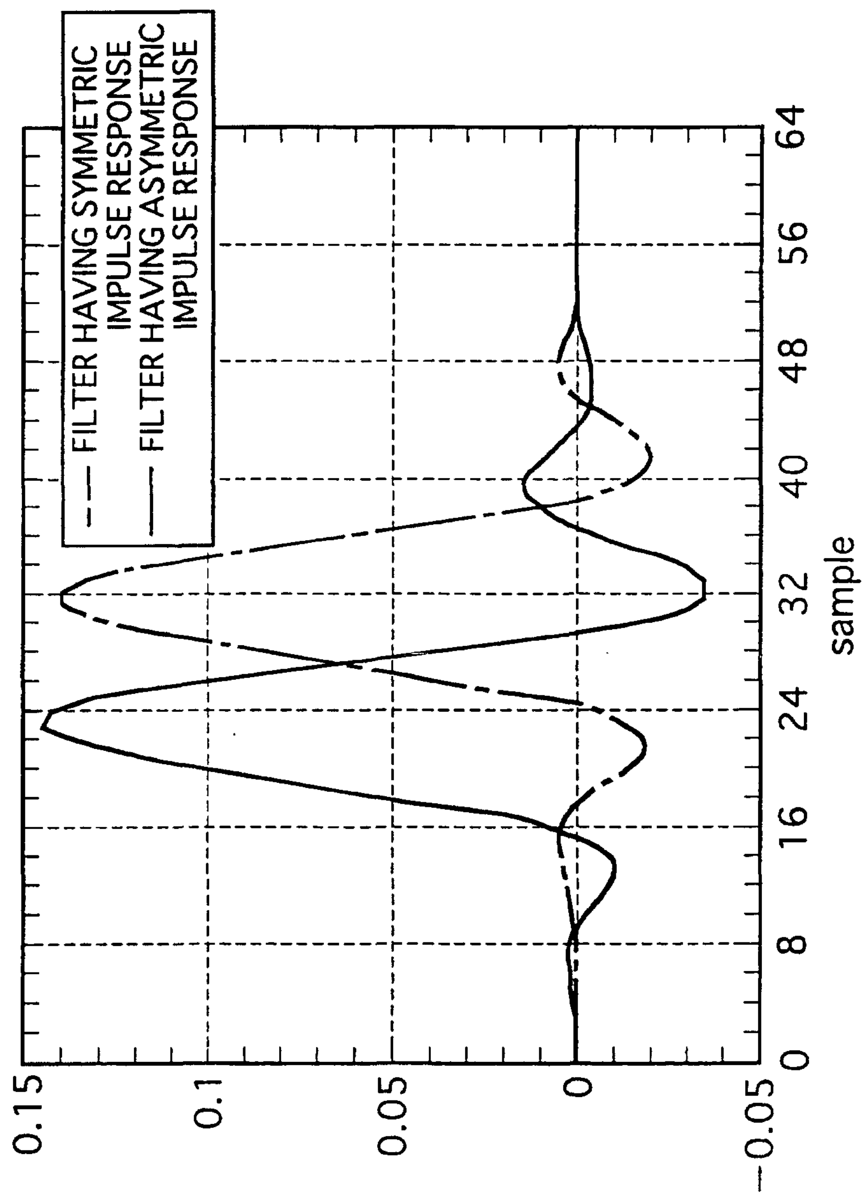
FILTER HAVING SYMMETRIC IMPULSE RESPONSE
FILTER HAVING ASYMMETRIC IMPULSE RESPONSE
0.15
0.1
0.05
0
−0.05
0
8
16
24
32
40
48
56
64
sample

FIG. 4

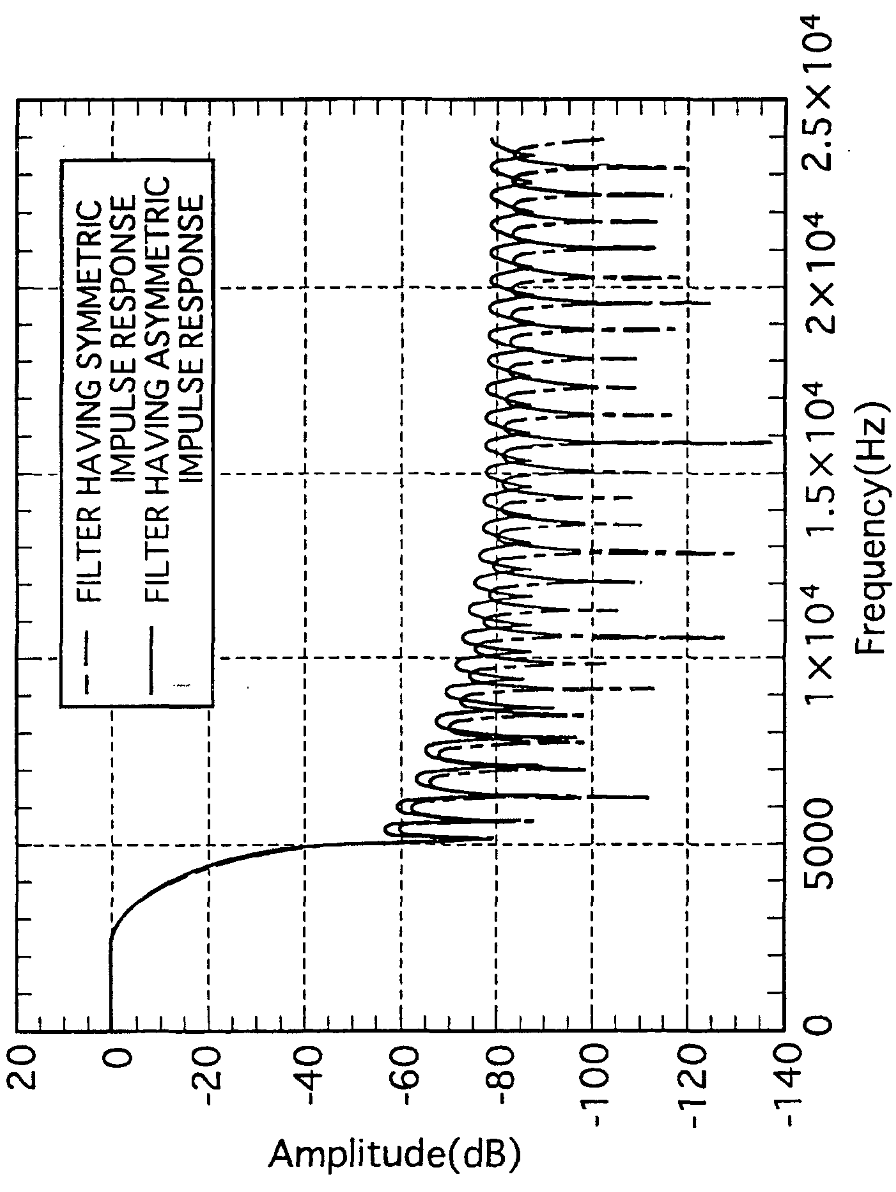
FILTER HAVING SYMMETRIC IMPULSE RESPONSE
FILTER HAVING ASYMMETRIC IMPULSE RESPONSE
Amplitude(dB)
20
0
-20
-40
-60
-80
-100
-120
-140
Frequency(Hz)
0
5000
1×10^4
1.5×10^4
2×10^4
2.5×10^4

F I G. 5

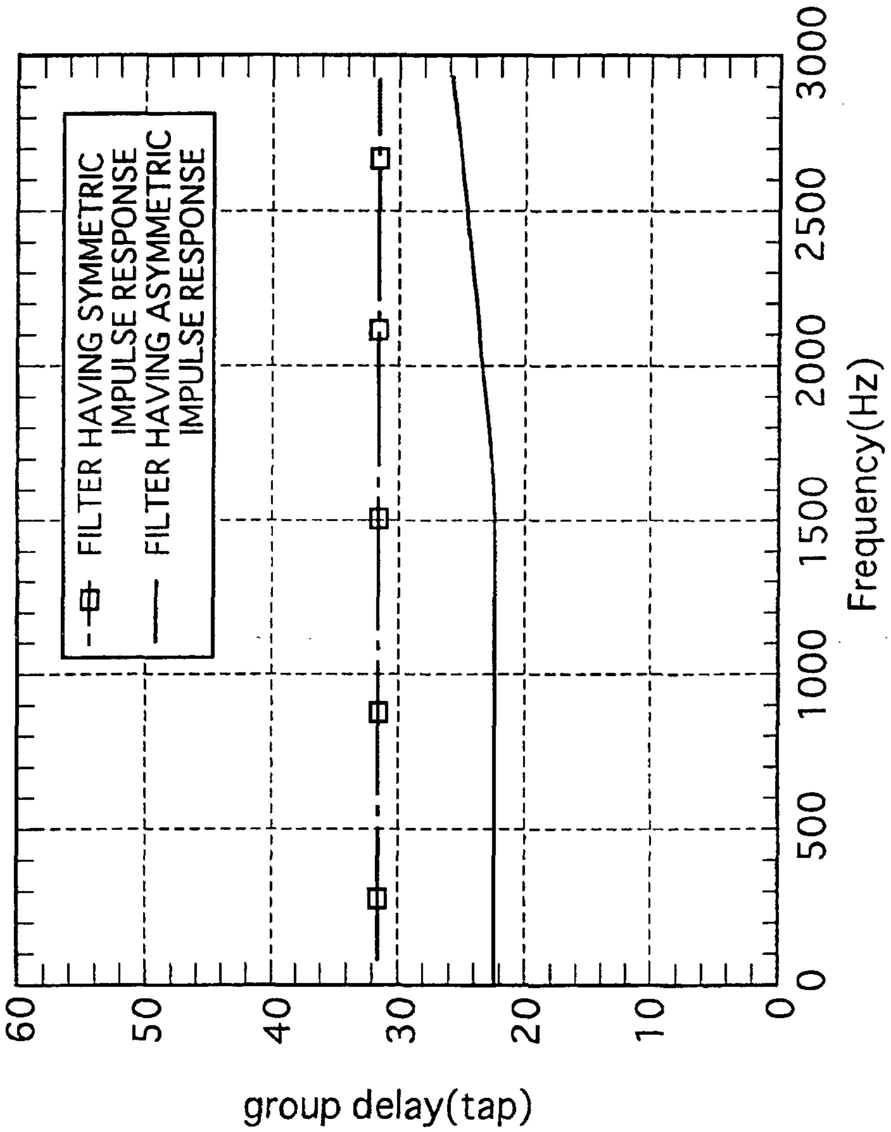
FILTER HAVING SYMMETRIC IMPULSE RESPONSE
FILTER HAVING ASYMMETRIC IMPULSE RESPONSE
group delay(tap)
0
10
20
30
40
50
60
Frequency(Hz)
0
500
1000
1500
2000
2500
3000

# F I G. 6

| SAMPLING NUMBER | COEFFICIENT OF REFERENCE FILTER HAVING SYMMETRIC IMPULSE RESPONSE | COEFFICIENT OF REFERENCE FILTER HAVING ASYMMETRIC IMPULSE RESPONSE |
|---|---|---|
| 1 | -9.3443E-05 | 4.1094E-05 |
| 2 | -9.8012E-05 | -3.7459E-05 |
| 3 | -6.0304E-05 | -6.1368E-05 |
| 4 | -6.7562E-06 | 6.9319E-05 |
| 5 | 1.5186E-05 | 4.0950E-04 |
| 6 | -4.4579E-05 | 9.1529E-04 |
| 7 | -2.1034E-04 | 1.4091E-03 |
| 8 | -4.5184E-04 | 1.5877E-03 |
| 9 | -6.6906E-04 | 1.0887E-03 |
| 10 | -7.0313E-04 | -3.8418E-04 |
| 11 | -3.7988E-04 | -2.9005E-03 |
| 12 | 4.1929E-04 | -6.1497E-03 |
| 13 | 1.6770E-03 | -9.3481E-03 |
| 14 | 3.1780E-03 | -1.1257E-02 |
| 15 | 4.4957E-03 | -1.0342E-02 |
| 16 | 5.0509E-03 | -5.0621E-03 |
| 17 | 4.2462E-03 | 5.7458E-03 |
| 18 | 1.6585E-03 | 2.2487E-02 |
| 19 | -2.7547E-03 | 4.4517E-02 |
| 20 | -8.4928E-03 | 7.0037E-02 |
| 21 | -1.4453E-02 | 9.6237E-02 |
| 22 | -1.9021E-02 | 1.1968E-01 |
| 23 | -2.0313E-02 | 1.3689E-01 |
| 24 | -1.6547E-02 | 1.4498E-01 |
| 25 | -6.4717E-03 | 1.4228E-01 |
| 26 | 1.0253E-02 | 1.2869E-01 |
| 27 | 3.2812E-02 | 1.0578E-01 |
| 28 | 5.9209E-02 | 7.6573E-02 |
| 29 | 8.6491E-02 | 4.4958E-02 |
| 30 | 1.1120E-01 | 1.5045E-02 |
| 31 | 1.2995E-01 | -9.5945E-03 |
| 32 | 1.4007E-01 | -2.6521E-02 |

F I G. 7

| SAMPLING NUMBER | COEFFICIENT OF REFERENCE FILTER HAVING SYMMETRIC IMPULSE RESPONSE | COEFFICIENT OF REFERENCE FILTER HAVING ASYMMETRIC IMPULSE RESPONSE |
|---|---|---|
| 33 | 1.4007E-01 | -3.4766E-02 |
| 34 | 1.2995E-01 | -3.4873E-02 |
| 35 | 1.1120E-01 | -2.8622E-02 |
| 36 | 8.6491E-02 | -1.8552E-02 |
| 37 | 5.9209E-02 | -7.3786E-03 |
| 38 | 3.2812E-02 | 2.5454E-03 |
| 39 | 1.0253E-02 | 9.6148E-03 |
| 40 | -6.4717E-03 | 1.3144E-02 |
| 41 | -1.6547E-02 | 1.3315E-02 |
| 42 | -2.0313E-02 | 1.0954E-02 |
| 43 | -1.9021E-02 | 7.2031E-03 |
| 44 | -1.4453E-02 | 3.2038E-03 |
| 45 | -8.4928E-03 | -1.5942E-04 |
| 46 | -2.7547E-03 | -2.3907E-03 |
| 47 | 1.6585E-03 | -3.3922E-03 |
| 48 | 4.2462E-03 | -3.3738E-03 |
| 49 | 5.0509E-03 | -2.7110E-03 |
| 50 | 4.4957E-03 | -1.8002E-03 |
| 51 | 3.1780E-03 | -9.5040E-04 |
| 52 | 1.6770E-03 | -3.3153E-04 |
| 53 | 4.1929E-04 | 2.1440E-05 |
| 54 | -3.7988E-04 | 1.6645E-04 |
| 55 | -7.0313E-04 | 1.9784E-04 |
| 56 | -6.6906E-04 | 1.9789E-04 |
| 57 | -4.5184E-04 | 2.1008E-04 |
| 58 | -2.1034E-04 | 2.3674E-04 |
| 59 | -4.4579E-05 | 2.5475E-04 |
| 60 | 1.5186E-05 | 2.3768E-04 |
| 61 | -6.7562E-06 | 1.7376E-04 |
| 62 | -6.0304E-05 | 7.2763E-05 |
| 63 | -9.8012E-05 | -3.8796E-05 |
| 64 | -9.3443E-05 | -1.3003E-04 |

F I G. 8

| | FILTER BANK ACCORDING TO PRESENT INVENTION | CONVENTIONAL FILTER BANK |
|---|---|---|
| DELAY (TAP) | 45 | 128 |

F I G. 9

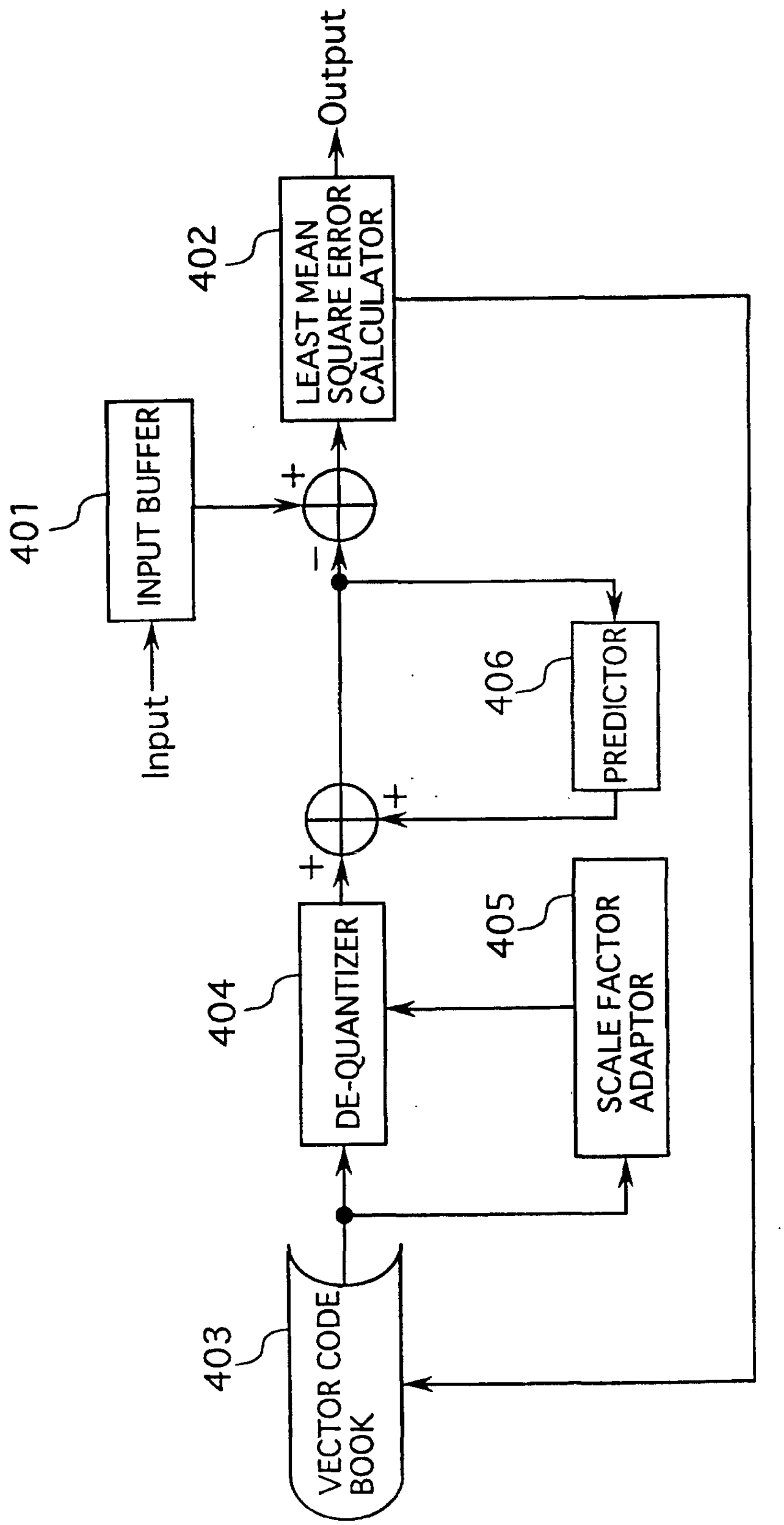
Input
401
INPUT BUFFER
402
LEAST MEAN SQUARE ERROR CALCULATOR
Output
+
−
403
VECTOR CODE BOOK
404
DE-QUANTIZER
405
SCALE FACTOR ADAPTOR
406
PREDICTOR
+
+

FIG. 10

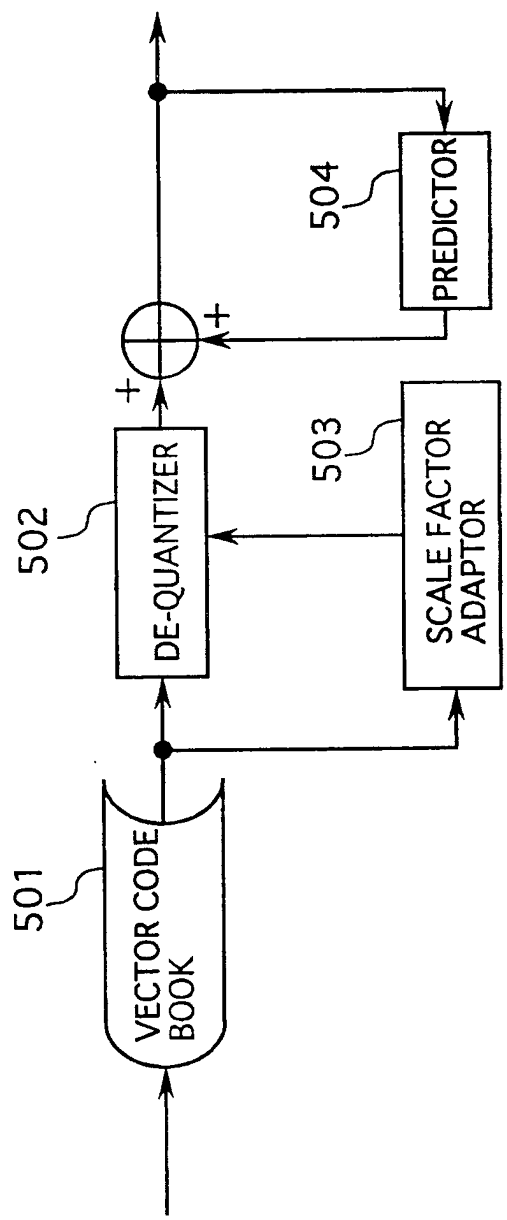
VECTOR CODE BOOK
501
DE-QUANTIZER
502
SCALE FACTOR ADAPTOR
503
PREDICTOR
504
+
+

FIG. 11

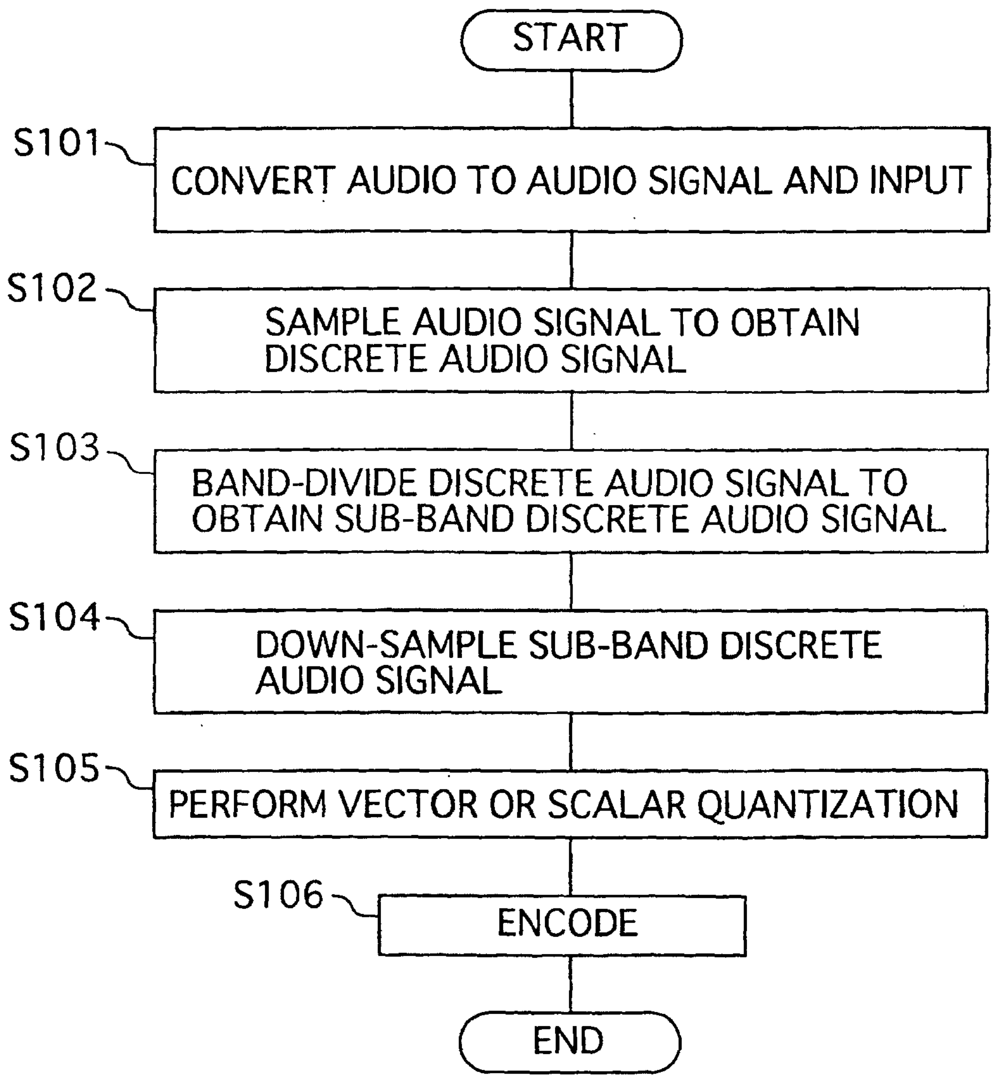
START
S101
CONVERT AUDIO TO AUDIO SIGNAL AND INPUT
S102
SAMPLE AUDIO SIGNAL TO OBTAIN DISCRETE AUDIO SIGNAL
S103
BAND-DIVIDE DISCRETE AUDIO SIGNAL TO OBTAIN SUB-BAND DISCRETE AUDIO SIGNAL
S104
DOWN-SAMPLE SUB-BAND DISCRETE AUDIO SIGNAL
S105
PERFORM VECTOR OR SCALAR QUANTIZATION
S106
ENCODE
END

F I G. 1 2

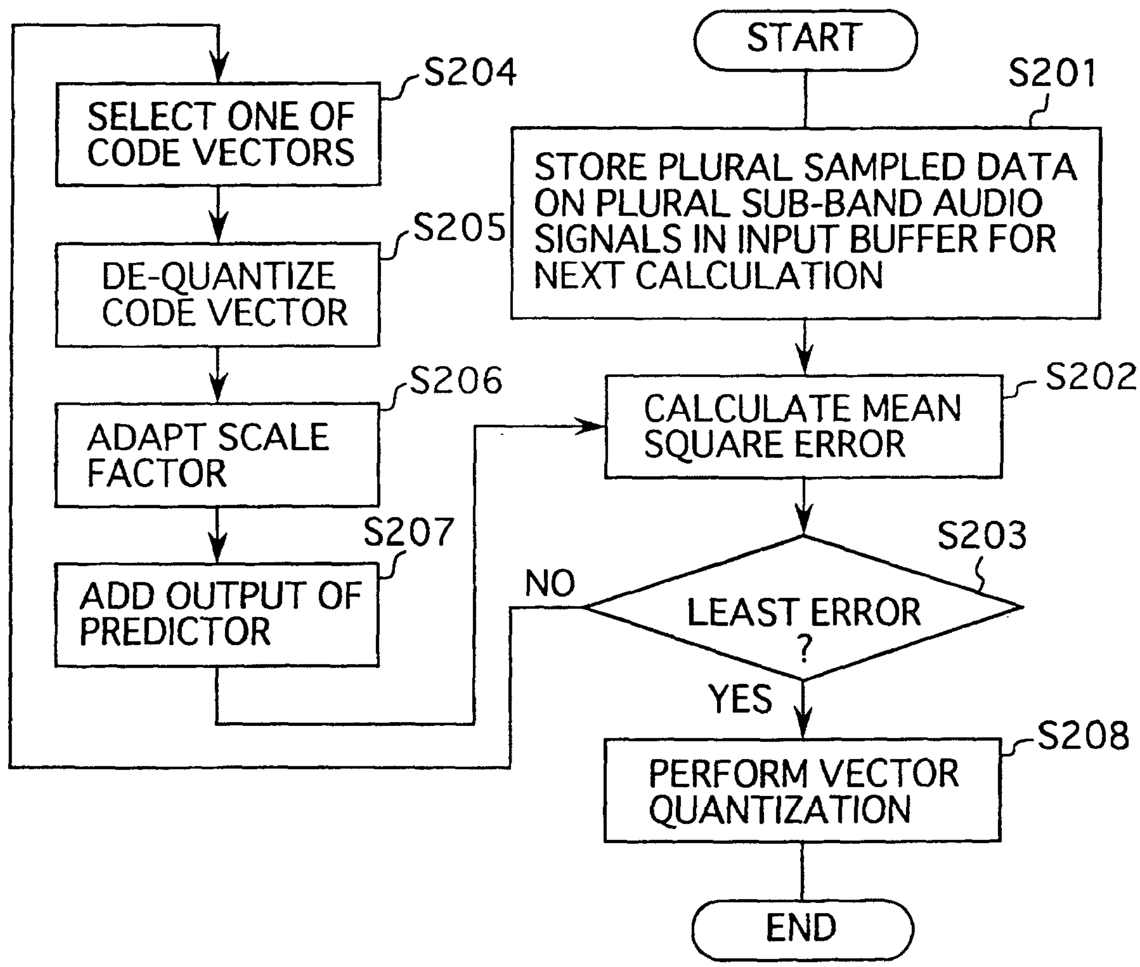
START
S201
STORE PLURAL SAMPLED DATA ON PLURAL SUB-BAND AUDIO SIGNALS IN INPUT BUFFER FOR NEXT CALCULATION
S202
CALCULATE MEAN SQUARE ERROR
S203
LEAST ERROR ?
NO
YES
S208
PERFORM VECTOR QUANTIZATION
END
S204
SELECT ONE OF CODE VECTORS
S205
DE-QUANTIZE CODE VECTOR
S206
ADAPT SCALE FACTOR
S207
ADD OUTPUT OF PREDICTOR

F I G. 1 3

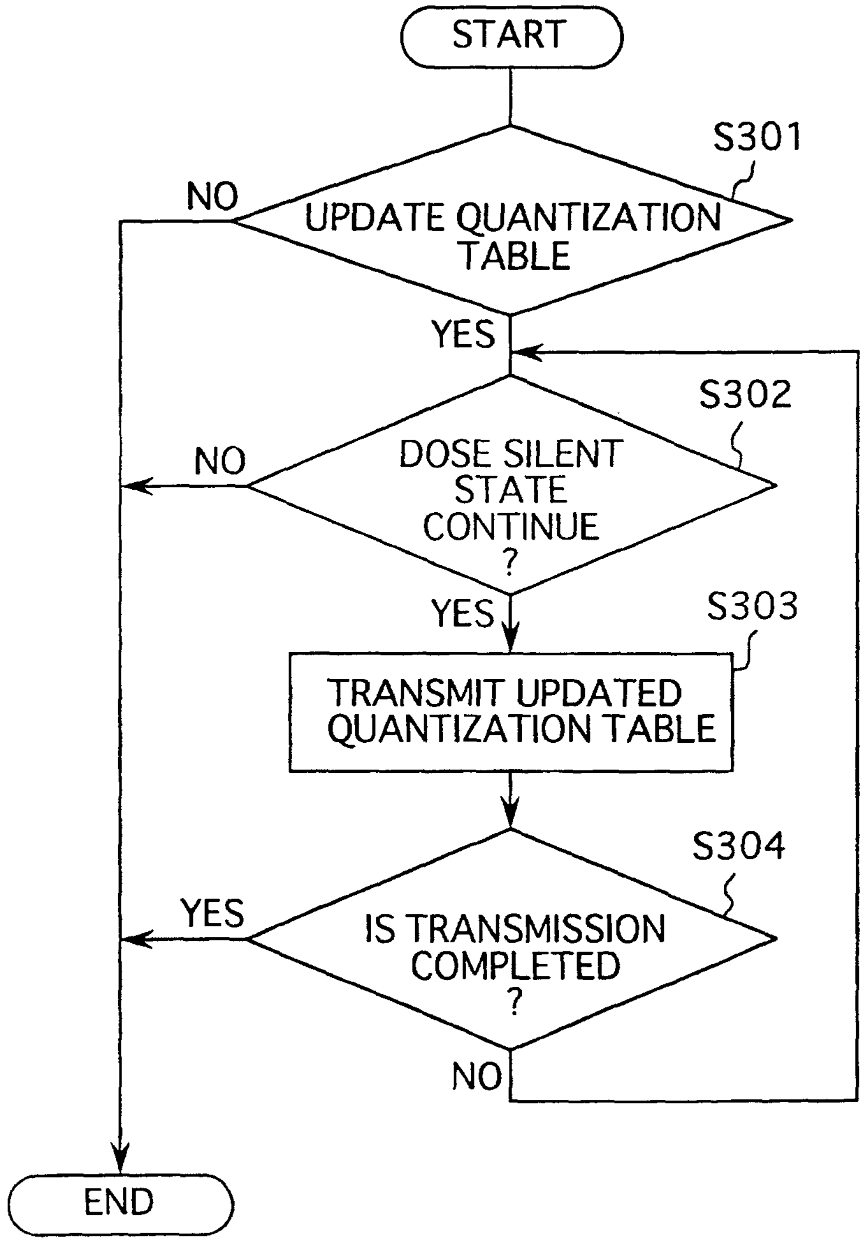
START
S301
NO
UPDATE QUANTIZATION TABLE
YES
S302
NO
DOSE SILENT STATE CONTINUE ?
YES
S303
TRANSMIT UPDATED QUANTIZATION TABLE
S304
YES
IS TRANSMISSION COMPLETED ?
NO
END

FIG. 14

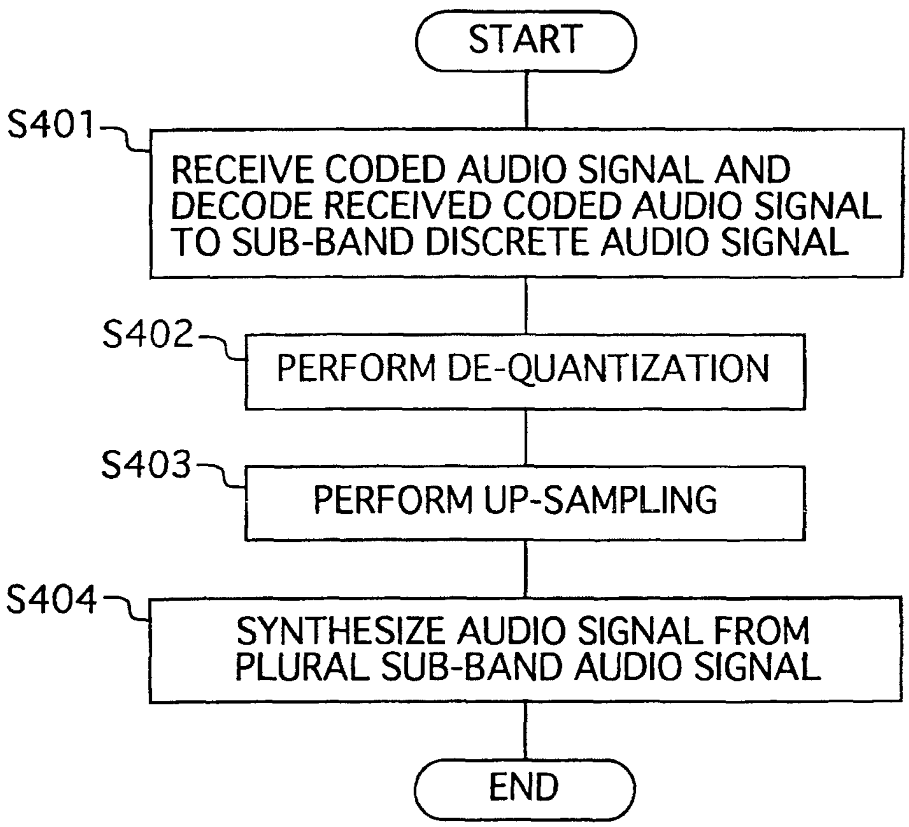
START
S401
RECEIVE CODED AUDIO SIGNAL AND DECODE RECEIVED CODED AUDIO SIGNAL TO SUB-BAND DISCRETE AUDIO SIGNAL
S402
PERFORM DE-QUANTIZATION
S403
PERFORM UP-SAMPLING
S404
SYNTHESIZE AUDIO SIGNAL FROM PLURAL SUB-BAND AUDIO SIGNAL
END

FIG. 15

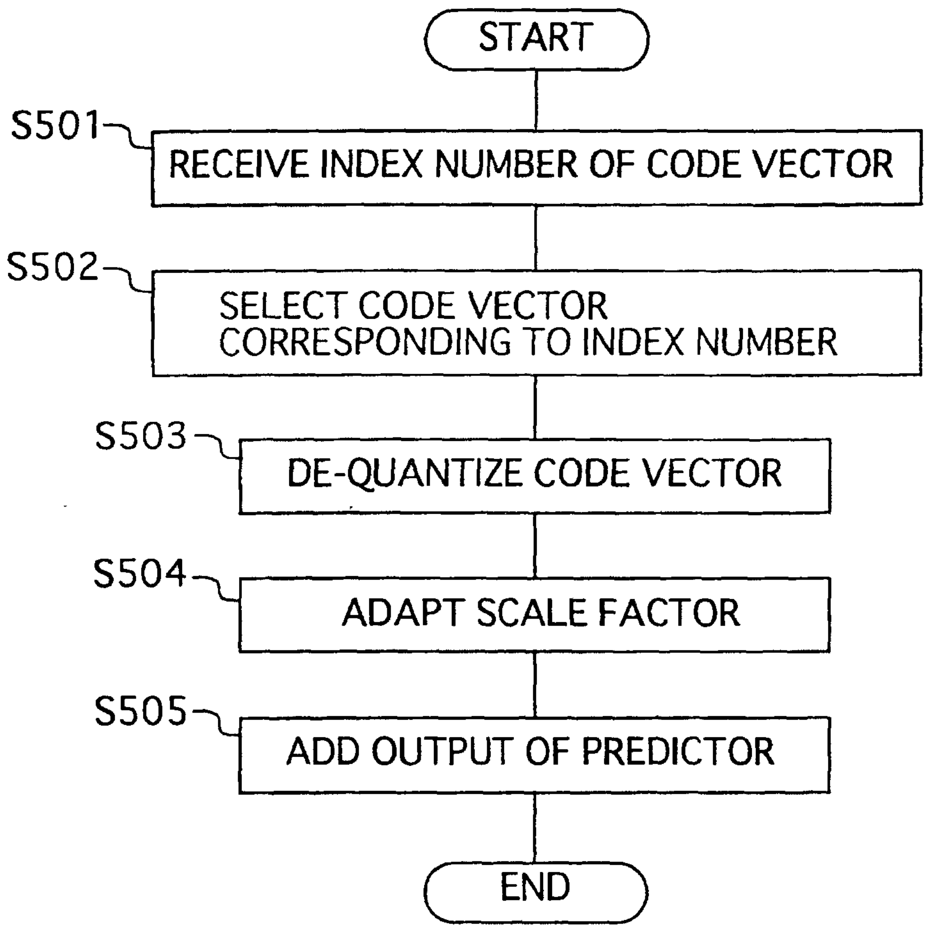
START
S501
RECEIVE INDEX NUMBER OF CODE VECTOR
S502
SELECT CODE VECTOR CORRESPONDING TO INDEX NUMBER
S503
DE-QUANTIZE CODE VECTOR
S504
ADAPT SCALE FACTOR
S505
ADD OUTPUT OF PREDICTOR
END

F I G. 1 6

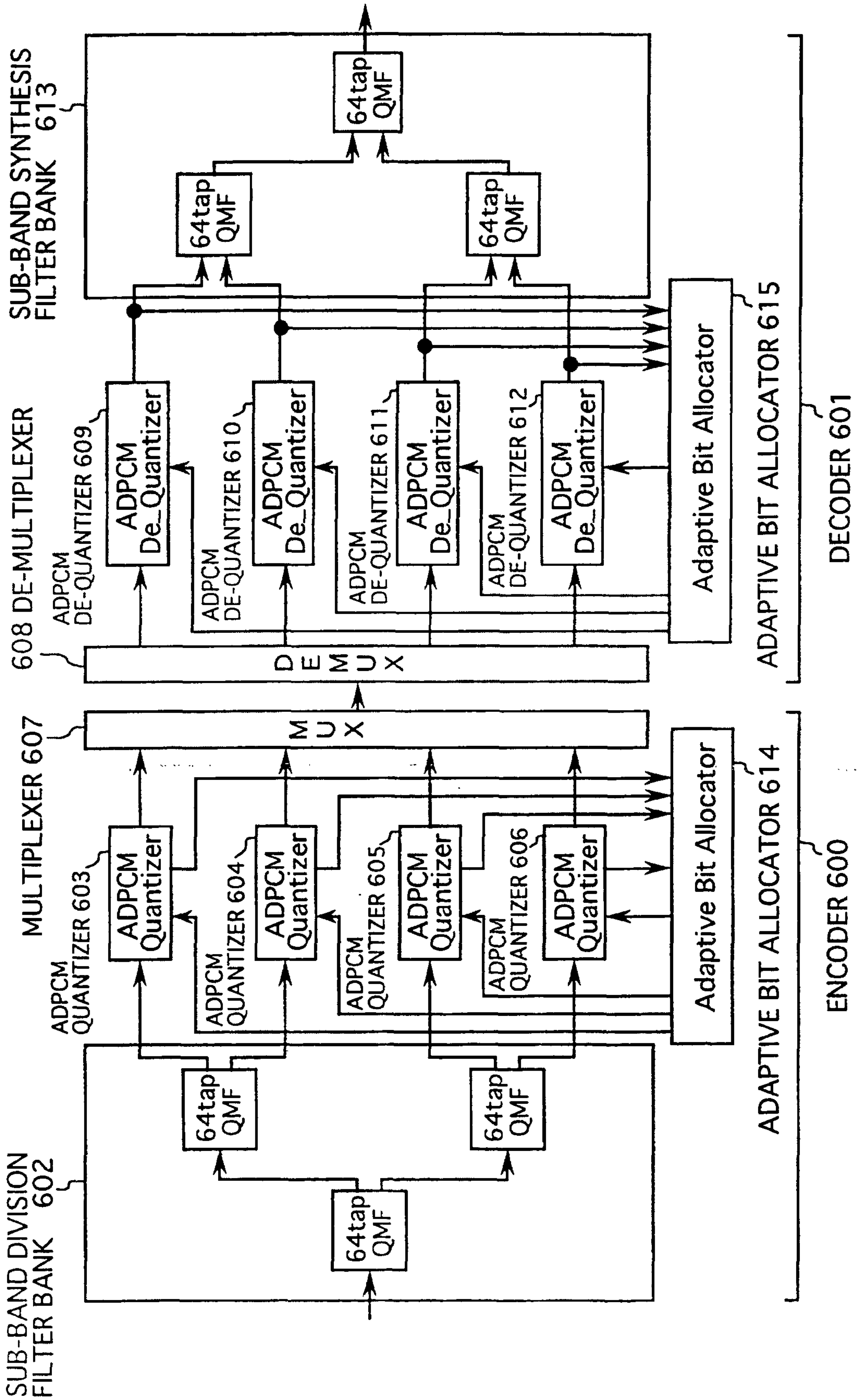
SUB-BAND DIVISION FILTER BANK 602
64tap QMF
64tap QMF
64tap QMF
ADPCM QUANTIZER 603
ADPCM QUANTIZER 604
ADPCM QUANTIZER 605
ADPCM QUANTIZER 606
ADPCM Quantizer
ADPCM Quantizer
ADPCM Quantizer
ADPCM Quantizer
Adaptive Bit Allocator
ADAPTIVE BIT ALLOCATOR 614
ENCODER 600
MULTIPLEXER 607
MUX
608 DE-MULTIPLEXER
DEMUX
ADPCM DE-QUANTIZER 609
ADPCM DE-QUANTIZER 610
ADPCM DE-QUANTIZER 611
ADPCM DE-QUANTIZER 612
ADPCM De_Quantizer
ADPCM De_Quantizer
ADPCM De_Quantizer
ADPCM De_Quantizer
Adaptive Bit Allocator
ADAPTIVE BIT ALLOCATOR 615
DECODER 601
SUB-BAND SYNTHESIS FILTER BANK 613
64tap QMF
64tap QMF
64tap QMF

# INTERNATIONAL SEARCH REPORT

International application No.
PCT/JP02/04384

**A. CLASSIFICATION OF SUBJECT MATTER**

Int.Cl[7] H03M7/38

According to International Patent Classification (IPC) or to both national classification and IPC

**B. FIELDS SEARCHED**

Minimum documentation searched (classification system followed by classification symbols)

Int.Cl[7] H03M7/38

Documentation searched other than minimum documentation to the extent that such documents are included in the fields searched

Jitsuyo Shinan Koho(Y1,Y2) 1926-1996 Toroku Jitsuyo Shinan Koho(U) 1994-2002
Kokai Jitsuyo Shinan Koho(U) 1971-2002 Jitsuyo Shinan Toroku Koho(Y2) 1996-2002

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| A | JP 59-127440 A (Nippon Telegraph & Telephone Public Corp.), 23 July, 1984 (23.07.84), Fig. 1 (Family: none) | 1-33 |
| A | JP 62-248327 A (Matsushita Electric Industrial Co., Ltd.), 29 October, 1987 (29.10.87), Fig. 1 (Family: none) | 1-33 |
| A | WO 89/07866 A (Audio Processing Technology Ltd.), 24 August, 1989 (24.08.89), Fig. 13a & JP 03-504787 A | 1-33 |

☐ Further documents are listed in the continuation of Box C. ☐ See patent family annex.

* Special categories of cited documents:
"A" document defining the general state of the art which is not considered to be of particular relevance
"E" earlier document but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| 31 July, 2002 (31.07.02) | 13 August, 2002 (13.08.02) |

| Name and mailing address of the ISA/ | Authorized officer |
|---|---|
| Japanese Patent Office | |
| Facsimile No. | Telephone No. |

Form PCT/ISA/210 (second sheet) (July 1998)